(19) Europäisches Patentamt
European Patent Office
Office européen des brevets

(11) **EP 1 745 550 B1**

(12) **EUROPÄISCHE PATENTSCHRIFT**

(45) Veröffentlichungstag und Bekanntmachung des Hinweises auf die Patenterteilung:
**05.03.2008  Patentblatt 2008/10**

(51) Int Cl.:
***H03L 7/185*** $^{(2006.01)}$

(21) Anmeldenummer: **05731726.5**

(22) Anmeldetag: **24.03.2005**

(86) Internationale Anmeldenummer:
**PCT/EP2005/051373**

(87) Internationale Veröffentlichungsnummer:
**WO 2005/112266 (24.11.2005 Gazette 2005/47)**

(54) **VERFAHREN UND VORRICHTUNG ZUM ERZEUGEN EINER SCHWINGUNG MIT VERÄNDERLICHER FREQUENZ**

METHOD AND DEVICE FOR PRODUCING AN OSCILLATION WITH VARIABLE FREQUENCY

PROCEDE ET DISPOSITIF POUR GENERER UNE OSCILLATION A FREQUENCE VARIABLE

(84) Benannte Vertragsstaaten:
**AT BE BG CH CY CZ DE DK EE ES FI FR GB GR HU IE IS IT LI LT LU MC NL PL PT RO SE SI SK TR**

(30) Priorität: **11.05.2004  DE 102004023220**

(43) Veröffentlichungstag der Anmeldung:
**24.01.2007  Patentblatt 2007/04**

(73) Patentinhaber: **Nokia Siemens Networks GmbH & Co. KG
81541 München (DE)**

(72) Erfinder: **WILHELM, Hartmut
81477 München (DE)**

(56) Entgegenhaltungen:
**US-A- 5 146 186          US-A- 5 847 615
US-A1- 2002 183 030          US-B1- 6 396 355**

## Beschreibung

Die vorliegende Erfindung betrifft eine Vorrichtung zum Erzeugen einer Schwingung mit veränderlicher Frequenz, die insbesondere in Kommunikationsgeräten wie Mobilfunkgeräten einsetzbar sind. Die veränderliche Frequenz soll nahezu stufenlos und - sofern eine Referenzfrequenz zur Verfügung steht - präzise einstellbar sein.

Für die Anwendung in Mobilfunkgeräten, wie Mobiltelefonen, nach dem GSM (Global System for Mobile Communications)-Standard soll die Frequenz schnell geändert werden können, damit sich eine hohe sogenannte Multislotklasse erzielen lässt, ohne dass eine Schaltung zum Erzeugen einer Frequenz mehrfach vorhanden sein muss.

Eine Schaltung bzw. Vorrichtung zum Erzeugen einer Frequenz soll ferner schnell nach Einschalten einer Stromversorgung die gewünschte Frequenz erreichen. Bei Anwendungen, bei denen eine Frequenz bzw. Schwingung nicht kontinuierlich benötigt wird, insbesondere bei Sende-/Empfangsvorrichtungen für TDMA (Time Division Multiple Access), spart es elektrische Energie, wenn die Schaltung in den Pausen, in denen die Schwingung nicht benötigt wird, abgeschaltet wird. Diese Pausen und die damit verbundene Einsparung sind um so größer, je kürzer die Vorlaufzeit ist, den die Schaltung zum Erreichen der gewünschten Frequenz benötigt.

Darüber hinaus soll es möglich sein, den Winkel der erzeugten Schwingung zu modulieren, um beispielsweise Information zu übertragen. Bei der Winkelmodulation kann es sich zum Beispiel um Phasenmodulation wie GMSK (Gaussian Minimum Shift Keying), Frequenzmodulation oder um den die Phase betreffenden Anteil einer Modulation handeln, die wie 8-PSK (PSK: Phase Shift Keying = Phasenumtastung) oder QAM (Quadratur-Amplitudenmodulation) sowohl die Phase als auch die Amplitude beeinflusst.

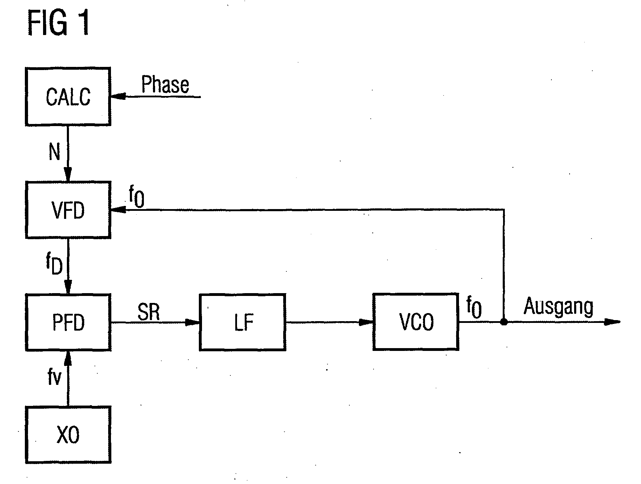

Eine Schaltung bzw. Vorrichtung zum Erzeugen einer Frequenzgemäß dem Stand der Technik ist in Figur 1 anhand einer Frequenzsyntheseschaltung in der Ausführung eines sogenannten Fractional-N-Synthesizers dargestellt. Dieser umfasst eine Phasenregelschleife (PLL: Phase Locked Loop) mit einem Vorwärtszweig bestehend aus einem Phasen-/Frequenzdetektor PFD (zum Vergleichen der Phasen bzw. Frequenzen zweier Signale), einem Schleifenfilter LF und einem spannungsgesteuerten Oszillator VCO (Voltage Controlled Oscillator), sowie einen Rückführungszweig zum zurückführen der vom VCO erzeugten Schwingung über einen variablen Frequenzteiler VFD an den PFD. Genauer gesagt, wird die vom VCO erzeugte Schwingung, beispielsweise mit einer Frequenz $f_O$ von 900 MHz, durch den variablen Frequenzteiler VFD mit hohem Teilungsfaktor N, für den beispielsweise (unter anderem) N=69 gilt, geteilt, so dass eine Schwingung mit einer heruntergeteilten Frequenz $f_D$ erzeugt wird. Dabei wird durch rasch wechselnde ganzzahlige Teilungsfaktoren, welche von einer Einrichtung CALC zum Umrechnen einer Phaseninformation in eine Abfolge von Teilungsfaktoren bereitgestellt werden, die herunterzuteilende Frequenz $f_O$ derart geteilt, dass sich als effektiver Teilungsfaktor N das gebrochene (englisch "fractional") Teilungsfaktorverhältnis ergibt. Die heruntergeteilte Frequenz $f_D$ wird schließlich einem ersten Eingang des PFD zugeführt, auf dessen zweiten Eingang eine von einem Quarzoszillator XO erzeugte Vergleichsfrequenz $f_V$ beispielsweise hier von 13 MHz gegeben wird. Der PFD vergleicht die beiden Frequenzen $f_D$ und $f_V$ (bzw. die zugehörigen Phasen) und gibt ein entsprechendes Differenzsignal als Regelsignal SR über das Schleifenfilter LF an den VCO zu dessen Steuerung aus. Etwaige Phasenfehler der vom VCO erzeugten Schwingung $f_O$ werden im Rückkopplungszweig der PLL ebenso mit dem hohen Teilungsfaktor vom PFD heruntergeteilt. Damit die Phasenfehler dennoch ausgeregelt werden, ist eine entsprechend hohe Verstärkung im Vorwärtszweig der PLL erforderlich. Damit dabei das Rauschen, z.B. das des PFD, nicht zu stark verstärkt wird, wird das Schleifenfilter LF schmalbandig ausgelegt.

Dies hat den Nachteil, dass eine Modulation, die etwa über ein wechselndes Teilungsverhältnis erzeugt wird, von dem für die Modulation zu schmalbandigen Schleifenfilter LF verzerrt wird. Dieser Nachteil kann nur mit erheblichem Aufwand, beispielsweise mit einer aufwändigen VCO-Schaltung, welche die VCO-Steilheit über den genutzten Frequenzbereich nahezu konstant hält, und Vorverzerrung des modulierenden Signals oder Zweipunktmodulation, bei der die Modulation zusätzlich mit einem DAC ("digital-to-analogue converter" = Digital-Analog-Umsetzer) zwischen Schleifenfilter LF und VCO eingespeist wird, überwunden werden. Ferner muss, falls die PLL mit dem schmalbandigen Schleifenfilter nicht schnell genug einrastet, die PLL-Bandbreite variabel ausgelegt werden, wobei zum Einrasten eine hohe und nach dem Einrasten eine niedrige Bandbreite gewählt wird.

Eine andere Möglichkeit, die Modulation aufzubringen um beispielsweise ein moduliertes Sendesignal zu erhalten, besteht darin, mit einem Fractional-N-Synthesizer eine Trägerschwingung zu erzeugen, die Modulation falls erforderlich in Inphase- und Quadraturkomponente zu zerlegen und mit einem Direktmodulator die Modulation in Inphase- und Quadraturkomponente aufzubringen. Jedoch erhöhen Direktmodulatoren das Rauschen. Ferner müssen die Inphase(I)- und Quadratur(Q)-Komponente digital-analog umgesetzt werden, und der Nullpunkt der Einheit aus DACs und Direktmodulator muss so abgeglichen werden, dass für I=Q=0 der Direktmodulator den Träger unterdrückt. Ein weiteres Problem ergibt sich beispielsweise bei GMSK ("Gaussian Minimum Shift Keying") dadurch, dass die Verstärkungen der Mischer für I und Q nie ganz gleich ausfallen und die Phasenverschiebung von 90° am Quadraturamplitudenmodulator nie ganz exakt getroffen wird. Dadurch schwankt die Hüllkurve hinter dem Direktmodulator ein wenig, und dies führt bei den meisten Sendeverstärkern durch sogenannte AM/PM-Konversion zu einer unzulässigen spektralen Verbreiterung des Sendesignals. Zudem kann eine Einstreuung des modulierten und verstärkten Sendesignals in den VCO des Fractional-N-Synthesizers zu einem zu großen Phasenfehler führen ("injection locking").

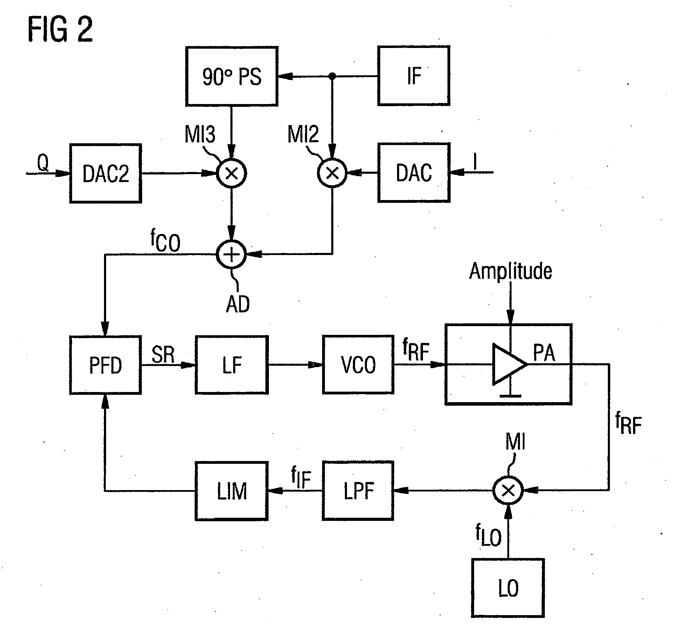

Es sei nun auf Figur 2 verwiesen, in der eine weitere Schaltung bzw. Vorrichtung zum Erzeugen einer Frequenz in der Form einer Phasenregelschleife (PLL), genauer gesagt in der Ausführung einer sogenannten Offset-PLL, dargestellt ist. Die Offset-PLL umfasst einen Phasen-/Frequenzdetektor PFD (zum Vergleichen der Phasen bzw. Frequenzen zweier Signale), einen Vorwärtszweig bestehend aus einem Schleifenfilter LF, einem spannungsgesteuerten Oszillator VCO und einem Sendeverstärker PA (Power Amplifier), sowie einen Rückführungszweig zum Zurückführen der vom VCO erzeugten Schwingung an den PFD bestehend aus einem Mischer MI, einem Tiefpassfilter LPF und einem Begrenzerverstärker LIM. Genauer gesagt, wird die vom VCO erzeugte Schwingung, beispielsweise mit einer Frequenz bzw. Sendefrequenz $f_{RF}$, in einen Eingang des Sendeverstärkers PA gegeben und in diesem verstärkt. Die Amplitude des verstärkten Signals kann über einen weiteren Eingang des Sendeverstärkers gesteuert werden. Das verstärkte Signal mit der Sendefrequenz $f_{RF}$ wird anschließend durch Mischung in dem Mischer MI mit einer Schwingung einer Frequenz $f_{LO}$ von einem Lokaloszillator LO auf eine Zwischenfrequenz $f_{IF} = |f_{RF}-f_{LO}|$ umgesetzt bzw. heruntergemischt. Nach Durchlaufen des Tiefpassfilters LPF, welcher unerwünschte Mischprodukte (insbesondere $f_{RF}+f_{LO}$) unterdrückt, und des Begrenzerverstärkers LIM wird das so gewonnene Signal einem ersten Eingang des PFD zugeführt. Der Begrenzerverstärker sorgt dafür, dass trotz unterschiedlicher Amplituden am Ausgang des Sendeverstärkers das Signal am ersten Eingang des PFD stets einen geeigneten Pegel hat. Zur Modulation der Sendefrequenz mit einem zu sendenden Signal wird auf den zweiten Eingang des PFD ein Signal mit einer Vergleichsfrequenz $f_{CO}$ gegeben, das durch einen im Folgenden beschriebenen und im oberen Abschnitt von Figur 2 dargestellten Quadraturamplitudenmodulator erzeugt wird. Das zu sendende Signal liegt im äquivalenten Basisband in Form von digitalen Abtastwerten I für die Inphasekomponente und Q für die Quadraturkomponente vor. Beim Quadraturamplitudenmodulator wird von einer Einrichtung IF zum Erzeugen einer Zwischenfrequenz (Intermediate Frequency) ein Signal zum einen direkt in einen zweiten Mischer MI2 gegeben, in dem es die von einem DAC analog gewandelte Inphasekomponente I in die Zwischenfrequenzlage umsetzt. Zum anderen wird das Signal von der Einrichtung IF über einen 90°-Phasenschieber PS in einen dritten Mischer MI3 gegeben, in dem es die von einem weiteren DAC2 analog gewandelte Quadraturkomponente Q ebenfalls in die Zwischenfrequenzlage umsetzt. Die in den beiden Mischern MI2 und MI3 umgesetzten Signale werden dann in einem Addierer AD zu einem Vergleichssignal mit der Frequenz $f_{CO}$ addiert und, wie bereits erwähnt, dem zweiten Eingang des PFD zugeführt. Der PFD vergleicht die beiden an seinen Eingängen anliegenden Frequenzen bzw. Phasen und gibt ein entsprechendes Differenzsignal als Regelsignal SR über das Schleifenfilter LF an den VCO zu dessen Steuerung aus.

Die Offset-PLL von Figur 2 kommt im Gegensatz zum Fractional-N-Synthesizer mit niedrigerer Verstärkung im Vorwärtszweig aus, denn die Sendefrequenz $f_{RF}$ wird nicht auf die Vergleichsfrequenz $f_{CO}$ heruntergeteilt, sondern durch Mischung mit der Schwingung des Lokaloszillators LO auf die Vergleichsfrequenz umgesetzt. Etwaige Phasenfehler auf der Sendefrequenz werden beim Heruntermischen eins zu eins auf die Vergleichsfrequenz umgesetzt. Die Modulation wird üblicherweise durch den oben erwähnten Quadraturamplitudenmodulator auf der Vergleichsfrequenz aufgebracht, die gleichzeitig der Zwischenfrequenz entspricht. Die PLL-Bandbreite kann hier so groß gewählt werden, dass die Modulation nahezu unverzerrt übertragen wird. Das Rauschen außerhalb des genutzten Kanals wird durch das Schleifenfilter gedämpft. Die Hüllkurve am Eingang des Sendeverstärkers ist, wie auch beim Fractional-N-Synthesizer, im Gegensatz zum Direktmodulator konstant. Wenn, wie bei der Polar Loop (vgl. auch Petrovic, V. und Gosling, W.: Polarloop transmitter. Electronic letters 15 (1979) 10, S. 286-288.), die Offset-PLL um den Sendeverstärker PA herum geschlossen wird, kann die Offset-PLL sogar etwaige schwankende Phasendrehungen des Sendeverstärkers ausgleichen.

Mit geringerer Genauigkeitsanforderung als beim Direktmodulator ergibt sich auch bei der Polar Loop unter Verwendung eines Quadraturamplitudenmodulators das Problem, dass der Nullpunkt der Einheit aus DACs und Quadraturamplitudenmodulator so abgeglichen werden muss, dass für I=Q=0 der Quadraturamplitudenmodulator den Träger unterdrückt.

Aus der US 5,847,615 ist ein Frequenzgenerator bekannt, welcher einen variablen Frequenzteiler (6), eine Regelschleife und eine Einrichtung zum Phasen- und/oder Frequenzvergleich (Phase Detector 2) aufweist. Der Frequenzteiler (6) hat einen ersten Eingang zum Eingeben einer Bezugsfrequenz (fr), einen zweiten Eingang zum Eingeben eines Steuersignals zum Festlegen des Teilungsverhältnisses (N) von der Bezugsfrequenz (fr) zu einer Ausgangsfrequenz (fr/N) und einem Ausgang zum Ausgeben der Ausgangsfrequenz (fr/N). Die Regelschleife weist in einem Vorwärtszweig eine Einrichtung (1) zum Erzeugen einer Schwingung mit einer ersten Frequenz (fo) auf, um daraus die an einem Ausgang anliegende Schwingung mit veränderlicher Frequenz abzuleiten. Die Regelschleife weist ferner in einem Rückführungszweig eine Einrichtung zur Frequenzumsetzung (8) auf, um die Schwingung mit veränderlicher Frequenz (fr) auf eine Schwingung mit zweiter Frequenz (fi) umzusetzen. Die Einrichtung zum Phasen- und/oder Frequenzvergleich (2) umfasst einen ersten Eingang (9) zum Eingeben der Schwingung mit zweiter Frequenz (fi), einen zweiten Eingang (5) zum Eingeben der Ausgangsfrequenz (fr/N), und einen Ausgang, der mit einem Anfang des Vorwärtszweigs gekoppelt ist und dafür ausgelegt ist, über einen Filter (3) ein Regelsignal für die Einrichtung (1) zum Erzeugen der Schwingung mit der ersten Frequenz (fo) auszugeben.

Es ist die Aufgabe der vorliegenden Erfindung, eine Vorrichtung zum Erzeugen einer Schwingung mit veränderlicher Frequenz zu schaffen, welche sowohl eine etwaige Modulation durch die Filterung kaum verzerrt als auch eine sehr gute Trägerunterdrückung - ohne einen Abgleich des Nullpunkts durchführen zu müssen - bietet.

Diese Aufgabe wird durch die Merkmale von Anspruch 1 gelöst. Vorteilhafte Ausgestaltungen sind Gegenstand der Unteransprüche.

Es ist Kern der Erfindung, eine Schaltung bzw. Vorrichtung zu schaffen, die im wesentlichen auf einer herkömmlichen Offset-PLL mit ihren bereits dargestellten Vorteilen aufbaut, wobei der Quadraturamplitudenmodulator durch Fractional-N-Technik ersetzt wird. Dadurch werden die Vorteile eines Fractional-N-Synthesizers gegenüber einer Offset-PLL nach Fig.2

- die Phasenmodulation mit digitalen Mitteln realisieren zu können und
- eine sehr gute Trägerunterdrückung zu bieten (Nullpunkt braucht nicht abgeglichen zu werden)

mit denen einer Offset-PLL gegenüber dem Fractional-N-Synthesizer

- schnell einzuschwingen,
- die Modulation bei der Filterung kaum zu verzerren und
- etwaige Phasendrehungen in der Sendeendstufe auszuregeln kombiniert.

Eine Vorrichtung zum Erzeugen einer Schwingung mit veränderlicher Frequenz umfasst dabei einen variablen Frequenzteiler mit einem ersten Eingang zum Eingeben einer Bezugsfrequenz, mit einem zweiten Eingang zum Eingeben eines Steuersignals zum Festlegen des Teilungsverhältnisses von der Bezugsfrequenz zu einer Ausgangsfrequenz, sowie mit einem Ausgang zum Ausgeben der Ausgangsfrequenz. Ferner hat die Vorrichtung eine Regelschleife mit einem Vorwärtszweig umfassend eine Einrichtung zum Erzeugen einer Schwingung mit einer ersten, insbesondere steuerbaren Frequenz, um daraus die Schwingung mit veränderlicher Frequenz abzuleiten, und mit einem Rückführungszweig umfassend eine Einrichtung zur Frequenzumsetzung und einen Lokaloszillator, um unter Verwendung einer Referenzfrequenz des Lokaloszillators die Schwingung mit veränderlicher Frequenz auf eine Schwingung mit zweiter Frequenz umzusetzen. Ferner weist die Vorrichtung eine Einrichtung zum Phasen- und/oder Frequenzvergleich auf. Diese Einrichtung umfasst einen ersten Eingang zum Eingeben der Schwingung mit zweiter Frequenz, einen zweiten Eingang zum Eingeben der Ausgangsfrequenz und einen Ausgang. Die Einrichtung zum Phasen- und/oder Frequenzvergleich bildet den Anfang des Vorwärtszweigs und ist dafür ausgelegt, ein Regelsignal für die Einrichtung zum Erzeugen der Schwingung mit erster Frequenz auszugeben. Erfindungsgemäß ist der erste Eingang des variablen Frequenzteilers mit dem Vorwärtszweig gekoppelt, so dass die Bezugsfrequenz von der zu erzeugenden Schwingung mit veränderlicher Frequenz abhängt.

Insbesondere bei Verwendung der Vorrichtung im Rahmen einer Sendevorrichtung zum Senden bzw. Abstrahlen von Nutzinformation in Form von Sendesymbolen kann die von der Einrichtung zum Erzeugen einer Schwingung erzeugte Schwingung mit der ersten Frequenz direkt als Schwingung mit der Sendefrequenz verwendet werden, oder es kann eine daraus abgeleitete Schwingung, deren Frequenz beispielsweise durch einen Frequenzteiler herabgesetzt wurde, als Sendefrequenz verwendet werden. Das bedeutet, dass im Folgenden zur einfacheren Darstellung unter einem abgeleiteten Signal ein Signal mit der Originalfrequenz (z.B. mit Teilungsfaktor gleich 1) oder ein von der Originalfrequenz abhängiges Signal beispielsweise mit geteilter oder vervielfachter Frequenz verstanden werden kann. Schließlich hat die Regelschleife noch eine Einrichtung zum Phasen- und/oder Frequenzvergleich umfassend einen ersten Eingang zum Eingeben der Schwingung mit zweiter Frequenz, einen zweiten Eingang zum Eingeben der Ausgangsfrequenz, und einen Ausgang, der den Anfang des Vorwärtszweigs bildet und dafür ausgelegt ist, ein Regelsignal für die Einrichtung zum Erzeugen der Schwingung mit erster Frequenz auszugeben.

Gemäß einer vorteilhaften Ausgestaltung der Vorrichtung kann der variable Frequenzteiler derart mit der Einrichtung zum Erzeugen einer Schwingung mit erster Frequenz verbunden sein, dass die erzeugte Schwingung mit erster Frequenz oder ein von dieser abgeleitetes Signal als Bezugsfrequenz in den ersten Eingang des variablen Frequenzteilers eingeht. Gemäß dieser Ausgestaltung wird also das Soll-Signal der Regelschleife mit der Ausgangsfrequenz, das am zweiten Eingang der Einrichtung zum Phasen- und/oder Frequenzvergleich anliegt, durch Herunterteilen der von der Einrichtung zum Erzeugen der Schwingung (mit erster Frequenz) erzeugten Schwingung gewonnen. Diese erzeugte Schwingung, aus der das Soll-Signal sozusagen auf einer Zwischenfrequenz abgeleitet wird, hat zwar im Allgemeinen einen Phasenfehler. Weil aber beim Herunterteilen - im Gegensatz zum Rückkopplungspfad der Regelschleife - auch ein etwaiger Phasenfehler der von der Einrichtung zum Erzeugen der Schwingung (mit erster Frequenz) erzeugten Schwingung mit heruntergeteilt wird, wirkt sich der über diesen Signalpfad kommende Fehler hinter der Einrichtung zum Phasen- und/oder Frequenzvergleich kaum aus und stört nicht. Es wird dabei davon ausgegangen, dass die von der Einrichtung zum Erzeugen der Schwingung (mit erster Frequenz) erzeugte Frequenz viel höher als die Zwischenfrequenz liegt, so dass sich ein hoher Teilungsfaktor ergibt.

Eine Besonderheit des hierbei verwendeten Verfahrens zum Erzeugen einer Schwingung mit veränderlicher Frequenz mittels einer Regelschleife ist, dass ein von der Schwingung mit erster Frequenz abgeleitetes Signal zum ersten und ein weiteres von der Schwingung mit erster Frequenz abgeleitetes Signal zum zweiten Eingang der Einrichtung zum Phasen- und/oder Frequenzvergleich geleitet werden. (Im einfachsten Fall eines Regelkreises liegt am Vergleicher zum einen eine Führungsgröße an, die einen Sollwert vorgibt, und zum anderen ein von der Regelgröße abgeleitetes Signal, das einen Istwert repräsentiert, aber nicht zwei von der Regelgröße, hier der ersten bzw. veränderlichen Frequenz, abgeleitete Signale.) Im normalen Betrieb (eingerastete Regelschleife) haben beide abgeleiteten Signale die gleiche, nämlich die zweite Frequenz. Damit sich eine bestimmte erste Frequenz ergibt, erfolgt die Ableitung der beiden Signale nach zwei verschiedenen Abhängigkeiten, insbesondere unter Verwendung einer Frequenzverschiebung bei dem zum ersten Eingang der Einrichtung zum Phasen- und/oder Frequenzvergleich führenden Signal und unter Verwendung einer Frequenzteilung bei dem zu deren zweiten Eingang führenden Signal.

Eine Ausgestaltung, bei der die Bezugsfrequenz von der zu erzeugenden Schwingung mit veränderlicher Frequenz abhängt, nutzt den gleichen Lokaloszillator für die Frequenzumsetzung im Rückkopplungspfad und für die Bezugsfrequenz des variablen Frequenzteilers. Die veränderliche Frequenz wird zweckmäßigerweise je nach ihrer Lage, insbesondere je nach dem zugehörigen Frequenzband, mit unterschiedlichen Frequenzen im Rückkopplungspfad auf eine Zwischenfrequenz umgesetzt. Um im Rückkopplungspfad mit unterschiedlichen Frequenzen umsetzen zu können, wird die Frequenz des Lokaloszillator veränderbar, insbesondere schaltbar ausgeführt. Eine Änderung der Frequenz des Lokaloszillators betrifft bei dieser Anordnung auch die Bezugsfrequenz, welche von der Frequenz des Lokaloszillators abgeleitet wird.

Zur Steuerung des variablen Frequenzteilers kann eine spezielle Berechnungseinrichtung (Einrichtung zum Erzeugen einer Abfolge von Teilungsfaktoren), ein sogenannter Fractional-N-Modulator, aus einem (insbesondere in digitaler Form) vorgegebenen Phasen- oder Frequenzverlauf eine rasch wechselnde Abfolge von Teilungsfaktoren berechnen, durch welche die Bezugsfrequenz, beispielsweise die von der Einrichtung zum Erzeugen der Schwingung (mit erster Frequenz) erzeugte Schwingung auf die (typischerweise modulierte) Zwischenfrequenz heruntergeteilt wird. Die berechneten Teilungsfaktoren werden mittels des Steuersignals dem zweiten Eingang des variablen Frequenzteilers zugeführt. Beim Fractional-N-Modulator tritt ein Quantisierungsgeräusch auf, weil er nur ganzzahlige Teilungsfaktoren ausgeben kann. Dieses Quantisierungsgeräusch wird bevorzugt spektral so geformt ("Noise-Shaping"), dass seine Leistungsdichte innerhalb der Durchlass-Bandbreite der Regelschleife niedrig ist. Die Quantisierungsrauschleistungsdichte steigt dann in größerem Frequenzabstand zur Zwischenfrequenz an und wird dort durch die Filterwirkung der Regelschleife gedämpft. Die Regelschleifen-Bandbreite wird bevorzugt einerseits so breit gewählt, dass die Modulation nicht unzulässig verzerrt wird, und andererseits so schmalbandig ausgelegt, dass nicht unnötig viel Rauschen durchgelassen wird. Für eine schmalbandigere Winkelmodulation, beispielsweise eine GMSK bei GSM, kann eine niedrigere PLL-Bandbreite gewählt werden als für den breitbandigeren Winkelmodulationsanteil von 8-PSK bei GSM.

Gemäß einer Ausgestaltung hat die Vorrichtung ferner Mittel zur Darstellung und/oder Zerlegung einer Modulationsinformation nach Amplitude und Winkel (insbesondere Phase oder Momentanfrequenz), d.h. zur polaren Signaldarstellung. Wie bereits erwähnt, kann dabei der Winkel bzw. die Phase als Eingangsgröße für die oben erwähnte Berechnungseinrichtung dienen. Eingangssignal solcher Mittel ist beispielsweise ein vorzugsweise digitales Signal in der Darstellung von Inphase- und Quadraturkomponente oder in der Darstellung einer Symbolfolge. Ausgegeben werden die Zeitfunktionen von Amplitude, wobei die Amplitude in bevorzugten Ausführungsformen in ein analoges Signal gewandelt werden muss, und Phase bzw. einer davon abgeleiteten Größe wie der Momentanfrequenz, wobei hier das Signal digital ausgegeben und weiterverarbeitet wird.

In einer bevorzugten Ausgestaltung teilt der variable Frequenzteiler die Bezugsfrequenz durch den vom Steuersignal vorgegebenen Wert, indem er von der Einrichtung zum Erzeugen einer Abfolge von Teilungsfaktoren das aktuelle Steuersignal N liest, eine entsprechende Anzahl N von Perioden der Bezugsfrequenz abzählt, dann an seinem Ausgang eine Schwingung bzw. einen Impuls ausgibt, und mit dem Lesen des nachfolgenden Wertes von N einen neuen Zählzyklus startet.

Gemäß einer weiteren Ausgestaltung hat die Vorrichtung ferner Mittel zur Erkennung der zeitlichen Lage der Zyklen am variablen Frequenzteiler. Die Information, wann ein Zählzyklus abgelaufen ist und ein neuer Teilungsfaktor N von der Einrichtung zum Erzeugen einer Abfolge von Teilungsfaktoren gelesen wurde, ist nützlich für die Einrichtung zum Erzeugen einer Abfolge von Teilungsfaktoren, weil sie genau dann den aktuellen Teilungsfaktor durch den folgenden Teilungsfaktor ersetzen sollte, wenn der aktuelle Wert vom variablen Frequenzteiler gelesen wurde.

Außerdem kann die Vorrichtung Mittel zur zeitlichen Verschiebung der Phase und/oder Amplitude aufweisen. Die Information, wann ein Zählzyklus abläuft, ist auch wichtig, um die zeitliche Lage des Phasen- bzw. Winkelsignals zu ermitteln. Da Amplitude und Phase zueinander synchron ausgegeben werden müssen, sollte die Amplitude entsprechend der zeitlichen Lage der Zählzyklen am variablen Frequenzteiler derart zeitlich verschoben werden können, dass Amplitude und Phase durch die Vorrichtung zeitsynchron kombiniert werden. Dazu wird zweckmäßigerweise auch eine Verbindung vom variablen Frequenzteiler zurück zur Einrichtung zum Erzeugen einer Abfolge von Teilungsfaktoren und zu den Mitteln zur Darstellung und/oder Zerlegung einer Modulationsinformation nach Amplitude und Winkel vorgesehen.

Alternativ oder zusätzlich können auch Mittel zur Verschiebung der zeitlichen Lage des Phasen- bzw. Winkelsignals, beispielsweise durch Umrechnung auf andere Abtastzeitpunkte, vorgesehen werden. Zur Bestimmung der erforderlichen Verschiebung sind auch hier Mittel zur Erkennung der zeitlichen Lage der Zyklen am variablen Frequenzteiler hilfreich.

Ferner können Mittel zur Bandbegrenzung der Bandbreite der Regelschleife (ungeachtet dessen, ob sie als Phasen- und/oder Frequenzregelschleife ausgebildet ist) in der Vorrichtung vorgesehen sein. Dabei können diese Mittel einen Schleifenfilter aufweisen, der insbesondere zwischen der Einrichtung zum Phasen- und/oder Frequenzvergleich und der Einrichtung zum Erzeugen einer Schwingung mit erster Frequenz angeordnet ist. In einer vorteilhaften Ausführungsform sind die Mittel zur Bandbegrenzung der Bandbreite der Regelschleife so gestaltet, dass die Bandbreite der Regelschleife beispielsweise durch Veränderung der Bandbreite des Schleifenfilters oder des sogenannten Chargepump-Stroms der Einrichtung zum Phasen- und/oder Frequenzvergleich verändert werden kann. Wenn beispielsweise keine Modulation erfolgen soll, sondern die erzeugte Schwingung zum Heruntermischen eines zu empfangenden Signals benötigt wird, liegt an der Einrichtung zur Berechnung einer Abfolge von Teilungsfaktoren auch kein Modulationssignal (bzw. lediglich konstante Phase oder Frequenz) an, und im Hinblick auf Rauschen und unerwünschte Nebenlinien im Spektrum (sogenannte "Spurious") ist eine schmale Bandbreite zweckmäßig. Zum schnellen Einrasten hingegen ist es vorteilhaft, bis zum Einrasten eine große Bandbreite zu wählen und danach die Bandbreite zu verringern. Hierbei können die Mittel zur Bandbegrenzung der Bandbreite der Regelschleife eine Einrichtung zum Erkennen umfassen, ob die Regelschleife eingerastet ist.

Durch den Teilungsfaktor N lässt sich nicht nur eine Modulation aufbringen, sondern auch in Grenzen die Mittenfrequenz verändern. Bei größeren Änderungen der Mittenfrequenz, wie sie beispielsweise beim Wechsel vom Band GSM900 ins Band GSM850 auftreten, wird bevorzugt zusätzlich die Frequenzumsetzung im Rückkopplungspfad verändert.

Gemäß einer weiteren vorteilhaften Ausgestaltung umfasst die Einrichtung zur Frequenzumsetzung einen Mischer bzw. Frequenzmischer mit einem ersten Eingang zum Eingeben der Schwingung mit erster Frequenz oder einem von dieser abgeleiteten Signal (insbesondere der Schwingung mit veränderlicher Frequenz), mit einem zweiten Eingang zum Eingeben der Schwingung mit der Referenzfrequenz oder einem von dieser abgeleiteten Signal, und mit einem Ausgang zum Ausgeben der Schwingung mit zweiter Frequenz. Dabei kann die von der Einrichtung zum Erzeugen einer Schwingung mit der Referenzfrequenz erzeugte Schwingung in der Frequenz umschaltbar sein.

Bei einer Ausgestaltung umfasst die Einrichtung zur Frequenzumsetzung außerdem einen Tiefpassfilter, der insbesondere dem Ausgang des Frequenzmischers nachgeschaltet ist. (Bei einer Frequenzumsetzung durch Mischung können außer der gewünschten Schwingung mit zweiter Frequenz weitere, unerwünschte Mischprodukte entstehen, die vom Tiefpassfilter unterdrückt werden.)

Des weiteren ist es möglich, dass bei der Regelschleife ferner eine Einrichtung zur Bandbegrenzung der Bandbreite der Regelschleife, insbesondere in Form eines Schleifenfilters, zwischen der Einrichtung zum Phasen- und/oder Frequenzvergleich und der Einrichtung zum Erzeugen einer Schwingung mit einer ersten Frequenz vorgesehen ist.

Gemäß einer weiteren vorteilhaften Ausgestaltung hat die Regelschleife ferner einen zweiten Frequenzteiler, der der Einrichtung zum Erzeugen einer Schwingung mit erster Frequenz nachgeschaltet ist und dafür ausgelegt ist, ein von der Schwingung mit erster Frequenz abgeleitetes Signal mit einem bestimmten Teilungsverhältnis zu dieser zu bilden. Dieser Frequenzteiler kann dazu dienen, die veränderliche Frequenz aus der ersten Frequenz abzuleiten, und er kann in seinem Teilungsverhältnis umschaltbar sein, damit die Schwingung mit veränderlicher Frequenz z.B. je nach Teilungsverhältnis im Band GSM900 oder DCS1800 liegt, ohne dass die Schwingung mit erster Frequenz in einem so weiten Bereich veränderbar zu sein braucht.

Insbesondere bei der Verwendung der Vorrichtung zum Erzeugen einer Schwingung mit veränderlicher Frequenz in einer Sendevorrichtung zum Senden bzw. Abstrahlen von Sendesymbolen kann der Vorwärtszweig der Regelschleife einen Leistungsverstärker zum Erzeugen eines Sendesignals auf der Basis der Schwingung mit erster Frequenz oder eines von dieser abgeleiteten Signals aufweisen, wobei der Leistungsverstärker der Einrichtung zum Erzeugen einer Schwingung mit erster Frequenz nachgeschaltet ist. Es ist hierbei denkbar, dass zwischen der Einrichtung zum Erzeugen einer Schwingung mit erster Frequenz und dem Leistungsverstärker der zweite Frequenzteiler vorgesehen ist, der dafür ausgelegt ist, die erste Frequenz auf eine niedrigere Sendefrequenz herunterzuteilen, die dann dem Leistungsverstärker zugeführt wird. In diesem Zusammenhang kann die Vorrichtung zum Erzeugen einer Schwingung mit veränderlicher Frequenz ferner eine Einrichtung zur Amplitudenmodulation des Sendesignals aufweisen, welche mit dem Leistungsverstärker verbunden oder in diesem integriert ist. Diese Einrichtung zur Amplitudenmodulation kann ferner in einer Amplitudenregelschleife integriert sein.

Gemäß einer weiteren Ausgestaltung kann die Vorrichtung zum Erzeugen einer Schwingung mit veränderlicher Frequenz eine Einrichtung zur Darstellung und/oder Zerlegung einer Modulationsinformation für das Sendesignal nach Amplitude und Winkel aufweisen.

Gemäß einem weiteren Aspekt der Erfindung wird eine Sendevorrichtung zum Senden bzw. Abstrahlen von Sendesymbolen geschaffen, die eine oben dargestellte Vorrichtung zum Erzeugen einer Schwingung mit veränderlicher Frequenz aufweist.

Gemäß einem weiteren Aspekt der Erfindung wird ein Kommunikationsgerät, insbesondere ein Kommunikationsendgerät geschaffen, das eine obige Sendevorrichtung aufweist. Derartige Geräte können dabei in der Ausführung eines Mobilfunkgeräts oder Mobiltelefons ausgebildet sein.

Bevorzugte Ausführungsformen der vorliegenden Erfindung werden nachfolgend Bezug nehmend auf die beiliegenden Zeichnungen näher erläutert. Es zeigen:

Figur 1 ein Blockschaltbild einer Schaltung zum Erzeugen einer Frequenz in der Ausführung eines sogenannten Fractional-N-Synthesizers gemäß dem Stand der Technik;

Figur 2 ein Blockschaltbild einer Schaltung zum Erzeugen einer Frequenz in der Ausführung einer sogenannten Offset-PLL gemäß dem Stand der Technik;

Figur 3 ein Blockschaltbild einer Schaltung zum Erzeugen einer Schwingung mit veränderlicher Frequenz gemäß einer bevorzugten Ausführungsform der Erfindung;

Figur 4 ein Blockschaltbild einer Schaltung zum Erzeugen einer Schwingung mit veränderlicher Frequenz gemäß einer weiteren bevorzugten Ausführungsform der Erfindung;

Figur 5 ein Blockschaltbild einer Schaltung zum Erzeugen einer Schwingung mit veränderlicher Frequenz, welche lediglich dem besseren Verständnis der beanspruchten Erfindung dient;

Figur 6 ein Blockschaltbild einer Schaltung zum Erzeugen einer Schwingung mit veränderlicher Frequenz, welche lediglich dem besseren Verständnis der beanspruchten Erfindung dient;

Figur 7 ein Diagramm, bei dem auf der Abszisse die Zeit und auf der Ordinate die Phase des Signals auf der Zwischenfrequenz aufgetragen ist, zum Veranschaulichen der Berechnung der Teilungsfaktoren N gemäß einer möglichen Ausführungsform der Erfindung.

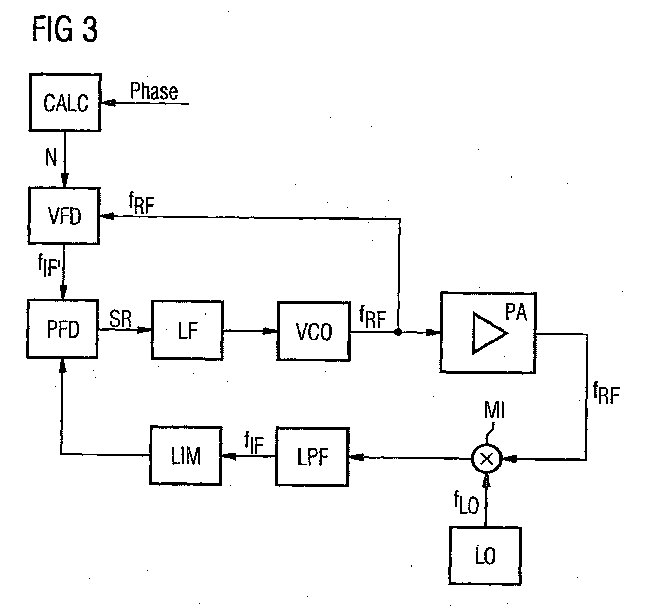

Es sei zunächst auf Figur 3 verwiesen, in der eine Schaltung gemäß der ersten Ausführungsform der Erfindung zum Erzeugen einer Schwingung mit veränderlicher Frequenz, insbesondere zum Erzeugen eines modulierten Sendesignals mit konstanter Hüllkurve dargestellt ist. Es soll eine Schwingung erzeugt werden, deren Frequenz sich in einem vorgegebenen Frequenzintervall nahezu stufenlos und recht präzise einstellen lässt. Kennzeichen der Ausführungsform ist, dass sie im wesentlichen auf einer in Figur 2 dargestellten Offset-PLL aufbaut, wobei der Quadraturamplitudenmodulator durch Fractional-N-Technik, wie sie beispielsweise anhand von Figur 1 erläutert wurde, ersetzt ist.

Die Schaltung bzw. Vorrichtung von Figur 3 umfasst wieder eine Regelschleife bzw. Offset-PLL mit einem Vorwärtszweig bestehend aus einem Phasen-/Frequenzdetektor PFD (zum Vergleichen der Phasen bzw. Frequenzen zweier Signale), einem Schleifenfilter LF, einem spannungsgesteuerten Oszillator VCO und einem Sendeverstärker PA (Power Amplifier), sowie mit einem Rückführungszweig zum Zurückführen der vom VCO erzeugten Schwingung an den PFD bestehend aus einem Mischer MI, einem Tiefpassfilter LPF und einem Begrenzerverstärker LIM. Genauer gesagt, wird die vom VCO erzeugte Schwingung, beispielsweise mit einer Frequenz bzw. Sendefrequenz $f_{RF}$ in einen Eingang des Sendeverstärkers PA gegeben und in diesem verstärkt. Das verstärkte Signal mit der Sendefrequenz $f_{RF}$ wird anschließend zum einen zur Abstrahlung verwendet (in den Figuren nicht dargestellt), zum anderen durch Mischung in dem Mischer MI mit einer Schwingung einer Frequenz $f_{LO}$ von einem Lokaloszillator LO auf eine Zwischenfrequenz $f_{IF}$ umgesetzt bzw. heruntergemischt. Nach Durchlaufen des Tiefpassfilters LPF und des Begrenzerverstärkers LIM wird das so gewonnene Signal einem ersten Eingang des PFD zugeführt.

In einem zweiten Rückführungszweig wird die vom VCO erzeugte Schwingung mit der Sendefrequenz $f_{RF}$ einem variablen Frequenzteiler (Fractional-N-Frequenzteiler) VFD als Bezugsfrequenz zugeführt. In diesem wird sie mit einem wechselnden Teilungsfaktor N, insbesondere einem hohem wechselnden Teilungsfaktor N (vgl. das Zahlenbeispiel zu Figur 1) geteilt, so dass eine Schwingung mit einer heruntergeteilten Frequenz bzw. Vergleichsfrequenz $f_{IF}$. erzeugt wird. Dabei wird aus einer digital vorliegenden Information über die Phase mittels einer Einrichtung (Fractional-N-Frequenzmodulator) CALC zum Umrechnen der Phaseninformation eine Abfolge von Teilungsfaktoren N berechnet, die nacheinander am variablen Frequenzteiler VFD als Steuersignal eingestellt werden. Bei der Berechnung können hierbei Mittel zur spektralen Formung des Quantisierungsrauschens das Quantisierungsrauschen beispielsweise durch Sigma-Delta-Verfahren spektral so formen, dass es von der Offset-PLL gut unterdrückt wird. Dazu wird deren Schleifenfilter LF bei GSM je nach Modulationsart so eingestellt, dass sich bei der einseitigen Bandbreite der geschlossenen Regelschleife eine Eckfrequenz von ein bis zwei MHz ergibt.

Bei der Berechnung der Abfolge von Teilungsfaktoren N muss berücksichtigt werden, dass die Frequenz, die geteilt wird, ihrerseits moduliert wird. Diesem Umstand wird dadurch Rechnung getragen, dass vor der Berechnung der Teilungsfaktoren N die Phase mit einem Faktor multipliziert wird. Wie später noch genauer ausgeführt wird, muss beispielsweise für $f_{RF}$ = 936 MHz und $f_{LO}$ = 976 MHz die Phase rund 4 % größer sein, als wenn der variable Frequenzteiler VFD mit einer unmodulierten Schwingung gespeist würde.

Das Signal vom VFD mit der Vergleichsfrequenz $f_{IF}$, wird schließlich auf einen zweiten Eingang des PFD gegeben. Der PFD vergleicht dann die beiden an seinen Eingängen anliegenden Signale bzw. Frequenzen und gibt ein entsprechendes Differenzsignal als Regelsignal SR über das Schleifenfilter LF an den VCO zu dessen Steuerung aus.

Wie schon eingangs bei den Ausführungen zu den Figuren 1 und 2 dargestellt, ist es bei einer Regelschleife üblich, dass ein Soll- und ein Istwert miteinander verglichen werden. Bei Phasen- oder Frequenzregelschleifen werden Soll- und Istwert der Phase oder der Frequenz von dem Phasen- oder Frequenzdetektor PFD verglichen. Dieses Bauelement hat, wie erwähnt, zwei Eingänge für die zu vergleichenden Signale und einen Ausgang für deren Abweichung bzw. das Differenzsignal. Am PFD liegt üblicherweise an einem Eingang eine Referenzschwingung mit einer Vergleichsfrequenz und an einem weiteren Eingang ein aus der von der Schaltung erzeugten Schwingung abgeleitetes Signal an.

Bei der hier vorgestellten Ausführungsform nach Figur 3 sind jedoch beide Eingangssignale des PFD, sowohl das vom VFD stammende Signal mit der Vergleichsfrequenz $f_{IF}$, als auch das vom Begrenzerverstärker LIM stammende Signal mit der Zwischenfrequenz $f_{IF}$ von der vom VCO erzeugten Schwingung mit der Frequenz $f_{RF}$ abgeleitet. Die Referenzfrequenz, welche auch diese Schaltung benötigt, kommt hier vom Lokaloszillator LO.

Durch diese Besonderheit wird der Zusammenhang zwischen Teilungsfaktor N (der zur Vereinfachung in der folgenden Rechnung nicht auf ganze Zahlen beschränkt sein soll) und der erzeugten Frequenz zwar komplizierter, er kann jedoch bei einer etwaigen Modulation als mathematische Näherung einfach durch eine Skalierung der Phase mit befriedigendem Ergebnis berücksichtigt werden.

Bei der folgenden Rechnung wird davon ausgegangen, dass die Frequenz $f_{LO}$ des Lokaloszillators LO über der Sendefrequenz $f_{RF}$ liegt.

Aus

$$f_{IF} = f_{LO} - f_{RF} \quad und \quad f_{RF} = N \cdot f_{IF'}$$

und unter der Annahme, dass $f_{IF}$ = $f_{IF}$.

folgt

$$N = f_{RF}/(f_{LO} - f_{RF}).$$

Aus einer differentiellen Betrachtung $df_{RF}/dN$ ergibt sich schließlich, dass sich $f_{RF}$ bei einer kleinen Veränderung von N mit dem Faktor $f_{RF}/f_{LO}$ stärker oder schwächer verändert, als wenn der variable Frequenzteiler bzw. Fractional-N-Frequenzteiler VFD mit einer festen Taktfrequenz als Bezugsfrequenz arbeiten würde. Umgekehrt folgt daraus, dass bei der Berechnung der Teilungsverhältnisse die Veränderung der Bezugsfrequenz des variablen Frequenzteilers dadurch kompensiert werden kann, dass zuvor die zu erzeugende Momentanfrequenzablage von der Mittenfrequenz oder deren Integral nach der Zeit, die Phase, mit dem Verhältnis $f_{LO}/f_{RF}$ skaliert wird.

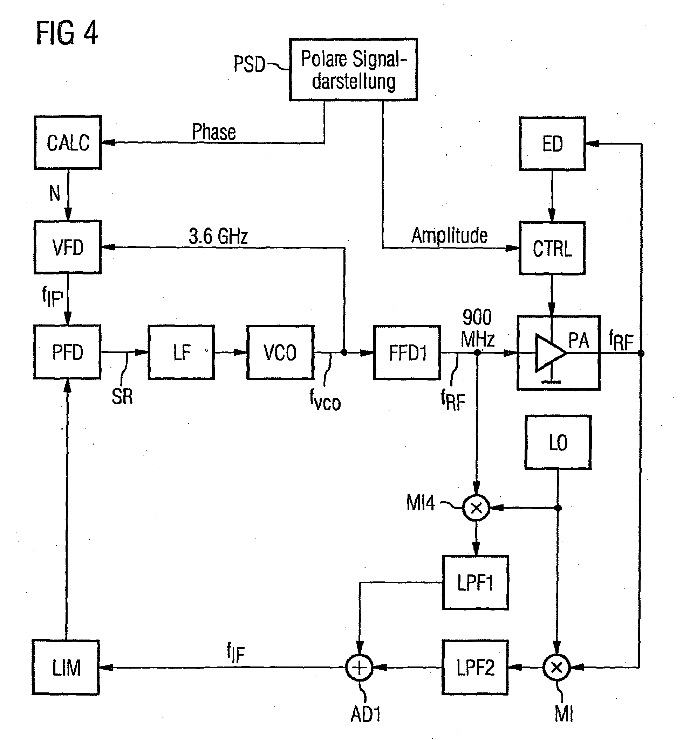

Es sei nun auf Figur 4 verwiesen, in der eine mögliche Erweiterung der Schaltung von Figur 3 zu einer sogenannten "Polar Loop" gezeigt ist. Zur Erläuterung gleicher bzw. ähnlicher Komponenten sei deshalb auf Figur 3 verwiesen.

Im Folgenden soll im Unterschied zu der Schaltung von Figur 3 angenommen werden, dass der VCO auf einem Vielfachen der Sendefrequenz schwingt, d.h. dass die vom VCO erzeugte Schwingung eine Frequenz $f_{VCO}$ (erste Frequenz) aufweist, welche ein Vielfaches der Sendefrequenz $f_{RF}$ (veränderliche Frequenz) ist. Dadurch steht am variablen Frequenzteiler VFD eine besonders hohe Frequenz $f_{VCO}$ zum Herunterteilen zur Verfügung, was für ein besonders niedriges Quantisierungsgeräusch genutzt wird. Die Frequenz $f_{VCO}$ des VCOs von beispielsweise rund 3,6 GHz wird bei einem GSM-Sender für eine Sendefrequenz $f_{RF}$ von rund 900 MHz von einem zweiten (bei Nutzung der Frequenzbänder GSM850 und GSM900 fest auf 4 eingestellten) Frequenzteiler FFD1 durch vier geteilt und dem Sendeverstärker PA zugeführt, wo durch die Versorgungsspannung eine Amplitude aufmoduliert wird. Die Bereitstellung der aufzumodulierenden Amplitude erfolgt über einen Amplitudenregelkreis bestehend aus einem Hüllkurvendetektor ED, einer Regeleinrichtung (z.B. umfassend einen DAC mit nachgeschaltetem Tiefpassfilter und einen "Low-dropout"-Regler, der insbesondere zwischen dem DAC und dem Sendeverstärker PA angeordnet ist) CTRL und dem Sendeverstärker PA. Als Amplitudensteuersignal erhält dabei die Regeleinrichtung CTRL von einer Einrichtung PSD eine Amplitudeninformation ausgehend von Sendesymbolen in polarer Signaldarstellung. Die entsprechende Phaseninformation der Sendesymbole in polarer Signaldarstellung geht an die Einrichtung CALC zum Umrechnen der Phaseninformation in eine Abfolge von Teilungsfaktoren N.

Durch die im Takt der Amplitude schwankende Versorgungsspannung schwankt auch die Phasenverschiebung, die der Sendeverstärker PA bewirkt. Die Regelschleife bzw. Offset-PLL (während eines Bursts mit hoher Sendeleistung PFD, LF, VCO, FFD1, PA, MI, LPF2, AD1, LIM) kompensiert jedoch den größten Teil dieser schwankenden Phasenverschiebung. Wenn die Ausgangsleistung einer Sendevorrichtung mit der in Figur 4 gezeigten Schaltung so niedrig ist, dass das hinter dem Sendeverstärker PA für die Rückkopplung ausgekoppelte Signal $f_{RF}$ zum Schließen der Offset-PLL nicht ausreicht, erhält der Rückkopplungszweig (dann gegeben durch MI4, LPF1, AD1, LIM) über den vor dem Sendeverstärker PA auskoppelnden Teilzweig (quasi als Brücke) ein so starkes Signal, dass der Begrenzerverstärker LIM den PFD mit ausreichendem Pegel versorgen kann. Dadurch bleibt die Offset-PLL auch ohne Sendeleistung geschlossen, und am Eingang des variablen Frequenzteilers VFD liegt eine definierte Frequenz an. Im normalen Betrieb, d.h. bei einer normalen bzw. hohen Ausgangsleistung der Vorrichtung, ist der über den zweiten Teilzweig (PA, MI, LPF2) den Zusammenführungspunkt AD1 erreichende Beitrag so viel größer, dass der vor dem Sendeverstärker PA ausgekoppelte Beitrag die Phase des zusammengeführten Signals nicht wesentlich verfälscht. Bevorzugt werden die Phasenlagen am Zusammenführungspunkt AD1 insbesondere für etwa gleich starke Signale der Teilzweige, d.h. sehr geringe Sendeleistung, so angepasst, dass sie sich nicht gegenseitig auslöschen. Dazu kann z.B. ein Phasenschieber in einen der beiden Teilzweige eingefügt werden. Wenn ein Laufzeitglied als Phasenschieber eingesetzt wird, kann eine Platzierung vor einem der Mischer MI/MI4 günstiger sein, weil dort die erforderliche Laufzeit geringer ist. Weitere Möglichkeiten, eine konstruktive Überlagerung zu fördern, bestehen je nach Phasendifferenz darin, die zu kombinierenden Signale zu subtrahieren statt zu addieren oder die vom LO stammenden Signale mit geeigneter Phasendifferenz an die beiden Mischer MI, MI4 zu führen. Durch die getrennten Mischer MI, MI4 und Tiefpassfilter LPF1, LPF2 wird eine zu große Rückkopplung vom Sendeverstärkerausgang auf den Sendeverstärkereingang vermieden.

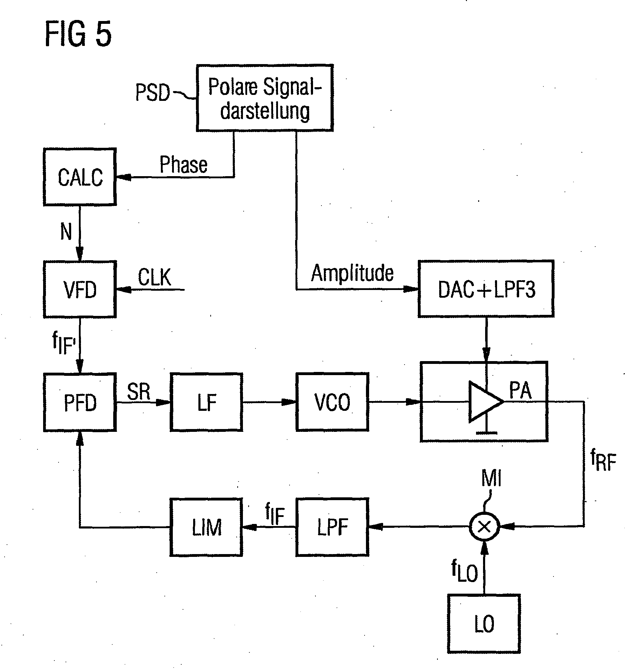

Zum besseren Verständnis der mit den Figuren 3 und 4 beschriebenen Ausführungsbeispiele der Erfindung sei nun auf Figur 5 verwiesen, in der eine Schaltung zum Erzeugen einer Schwingung mit veränderlicher Frequenz gezeigt ist, bei der im Vergleich zu der in Figur 4 dargestellten Schaltung keine Regelschleife für die Amplitude vorgesehen ist. Ferner wurde die Offset-PLL (PFD, LF, VCO, PA, MI, LO, LPF, LIM) in ihren Komponenten reduziert und entspricht der in Figur 3 gezeigten Offset-PLL. Zur Erläuterung gleicher bzw. ähnlicher Komponenten sei deshalb auf die Figuren 3 und 4 verwiesen.

Bei der Schaltung nach Figur 5 ist die Steuer- bzw. Versorgungsspannung des Sendeverstärkers PA und damit die Amplitude des Sendesignals gesteuert. Ein leistungsstarker DAC, der beispielsweise durch Pulsmodulation und nachfolgende Tiefpassfilterung mittels eines Tiefpassfilters LPF3 eine Betriebsspannung in eine variable Spannung umsetzt, liefert so eine variable Versorgungsspannung für den Sendeverstärker und ermöglicht dadurch die Veränderung der momentanen (insbesondere durch Modulation veränderlichen) und mittleren (insbesondere von der Sendeleistungsstufe abhängigen) Leistung. Ferner ist der variable Frequenzteiler VFD nicht mit dem spannungsgesteuerten Oszillator verbunden, sondern wird mit einer festen Taktfrequenz CLK beispielsweise von einem weiteren Lokaloszillator als Bezugsfrequenz versorgt. Vorteile sind, dass auch bei ausgerasteter Offset-PLL ein definierter Takt anliegt, dass sich Amplitude und Phase in definierter Weise zu einander synchronisieren lassen, dass die mit einer Näherung verbundene Skalierung der Phase oder Frequenz entfällt sowie dass eine etwaige schwankende Phasendrehung des Sendeverstärkers noch besser ausgeregelt wird, weil im Gegensatz zur Schaltung nach Figur 4 keine Signale zwischen VCO und PA abzweigen. Da bei dieser Schaltung ein Ausrasten der Offset-PLL weitgehend unschädlich ist, wenn die Sendeleistung null ist, bedarf hier der Rückführungszweig keiner Auskopplung vor dem Sendeverstärker PA. (Allerdings kann die variable Frequenz nicht zum Empfang genutzt werden, wenn die Schleife nur bei aktivem Sendeverstärker geschlossen ist.)

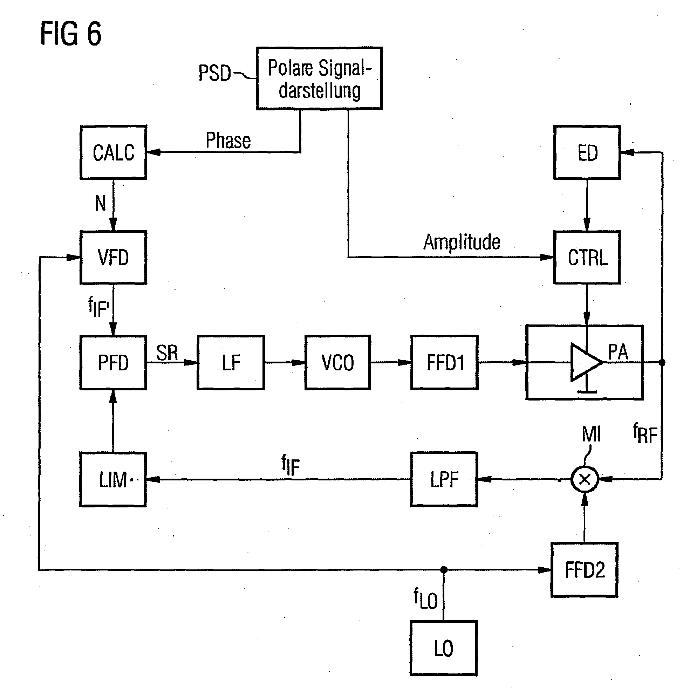

Zum besseren Verständnis der mit den Figuren 3 und 4 beschriebenen Ausführungsbeispiele der Erfindung sei nun auf Figur 6 verwiesen, in der eine Schaltung zum Erzeugen einer Schwingung mit veränderlicher Frequenz gezeigt ist. Die Schaltung weist dabei eine Amplitudenregelschleife entsprechend der in Figur 4 gezeigten Amplitudenregelschleife auf, jedoch wird wie in der Schaltung von Figur 5 eine unmodulierte Schwingung als Bezugsfrequenz - hier $f_{LO}$ - für den variablen Frequenzteiler VFD verwendet. Zur Erläuterung gleicher bzw. ähnlicher Komponenten sei deshalb auf die Figuren 4 und 5 verwiesen.

Um eine für den GSM-Mobilfunk ausreichend reine Schwingung zu erzeugen, sollte die Bezugsfrequenz $f_{LO}$ für den variablen Frequenzteiler VFD größer als 2 GHz und damit größer sein als die Frequenz, mit der das Signal am Ausgang des Sendeverstärkers PA heruntergemischt wird. Eine solch hohe Frequenz ist üblicherweise als Taktfrequenz nicht ohnehin vorhanden, sondern müsste gezielt bereitgestellt werden. Um Hardware-Aufwand zu sparen, kann die Erzeugung dieser Taktfrequenz mit der Bereitstellung der Frequenz zum Heruntermischen durch einen Lokaloszillator LO kombiniert werden. Wenn beispielsweise eine Schwingung mit einer Frequenz $f_{RF}$ von 1760 MHz erzeugt werden soll und die Zwischenfrequenz $f_{IF}$ bei 40 MHz liegt, kann der Lokaloszillator LO auf einer Frequenz $f_{LO}$ = 3,6 GHz schwingen. Einerseits wird diese Schwingung dem variablen Frequenzteiler VFD als Bezugsfrequenz $f_{LO}$ zugeführt. Weil diese Frequenz vergleichsweise hoch ist, ergeben sich große Teilungsfaktoren N, die in relativ feinen Abstufungen geändert werden können. Andererseits werden die 3,6 GHz von einem dritten (bei Nutzung der GSM-Frequenzbänder bei 1800 und 1900 MHz fest auf 2 eingestellten) Frequenzteiler FFD2 auf 1800 MHz halbiert, so dass die Frequenz von 1760 MHz am Ausgang des Sendeverstärkers PA auf die Zwischenfrequenz von 40 MHz heruntergemischt wird.

Beim Frequenzteiler FFD2 wird also - ebenso wie bei FFD1 - der Frequenzteiler nicht im Takt der Modulation verändert, sondern er bleibt für eine Betriebsart konstant. Beispielsweise wird zur Erzeugung einer Schwingung in den 850-MHz- und 900-MHz-Bändern durch vier und zur Erzeugung einer Schwingung in den 1800-MHz- und 1900-MHz-Bändern durch zwei geteilt.

Je nach Bereich, in dem die Zwischenfrequenz $f_{IF}$ verändert werden kann, und je nach Bereich oder Bändern, in dem/denen die Frequenz der erzeugten Schwingung $f_{RF}$ verändert werden kann, wird die Frequenz $f_{LO}$ des Lokaloszillators LO verändert. Sowohl die Frequenz des Lokaloszillators LO als auch die Zwischenfrequenz werden von der Einrichtung CALC zum Umrechnen der Phaseninformation (von Sendesymbolen in polarer Darstellung) in eine Abfolge von Teilungsfaktoren berücksichtigt. Wenn ein Sendesignal bei 900 MHz erzeugt werden soll, wird beispielsweise der Lokaloszillator LO auf eine Frequenz $f_{LO}$ von 3,8 GHz eingestellt, und diese Frequenz wird vom Frequenzteiler FFD2 durch vier auf 950 MHz geteilt, so dass sich eine Zwischenfrequenz von 50 MHz ergibt. Der Frequenzteiler VFD mit einstellbarem Teilungsfaktor N hat in diesem Fall also eine andere Bezugsfrequenz $f_{LO}$, und im Allgemeinen hängt die Bezugsfrequenz unmittelbar von der Frequenz des Lokaloszillators und somit mittelbar von der Frequenz der zu erzeugenden Schwingung ab.

Falls die Frequenz des Lokaloszillators für jeweils ein Band fest ist, ändert sich die Zwischenfrequenz über einen relativ großen Bereich. Wenn das GSM1800-Uplinkband als Beispiel genommen wird, beträgt bei einer am Mischer MI anliegenden, auf 1800 MHz halbierten LO-Frequenz die Zwischenfrequenz zwischen 15 MHz bei einer erzeugten Schwingung von 1785 MHz und 90 MHz bei einer erzeugten Schwingung von 1710 MHz. Bei einer bevorzugten Ausführungsform ist die für das Noise-Shaping relevante Abtastfrequenz die Ausgangsfrequenz des VFD und damit die Zwischenfrequenz. Eine so große Änderung der Abtastfrequenz des Noise-Shapings wie in diesem Beispiel zwischen 15 MHz und 90 MHz ist problematisch, weil sich bei gegebener Übertragungsfunktion des Noise-Shapings im z-Bereich das Rauschspektrum mit der Abtastfrequenz ändert. Eine Abhilfe besteht darin, die Übertragungsfunktion des Noise-Shapings an die Abtastfrequenz anzupassen. Alternativ oder zusätzlich kann das Sendeband, beispielsweise das Band von 1710 MHz bis 1785 MHz, in Sub-Bänder unterteilt werden, für die unterschiedliche Frequenzen am Lokaloszillator gewählt werden, so dass die Zwischenfrequenz in einem engeren Bereich gehalten wird. Bei einer Ausgestaltung lässt sich die Frequenz des Lokaloszillators $f_{LO}$ in so kleinen Schritten einstellen, dass die Kanalwahl über $f_{LO}$ erfolgen kann. Die Zwischenfrequenz kann dann konstant gehalten werden.

Wie bereits angesprochen können die in den Figuren 3 und 4, welche Ausgestaltungen der Erfindung zeigen und die in den Figuren 5 und 6 gezeigten Schaltungen, welche lediglich dem besseren Verständnis der Erfindung dienen, zum Erzeugen einer Schwingung mit veränderlicher Frequenz Bestandteil einer Sendevorrichtung zum Senden bzw. Abstrahlen von Sendesymbolen als Nutzinformationen in Kommunikationsgeräten, wie Mobilfunkgeräten bzw. Mobiltelefonen, eingesetzt werden, welche beispielsweise nach dem GSM-, UMTS(Universal Mobile Telecommunications System)- oder einem anderen Mobilfunkstandard arbeiten. Bevorzugt wird dazu der Ausgang des Sendeverstärkers mit einem Anpassnetzwerk verbunden, welches die Impedanz an eine Antenne oder eine genormte Schnittstelle mit 50 Ω anpasst. Die Auskopplung eines kleinen Teils des Sendesignals für den Rückführungszweig erfolgt beispielsweise über Koppler, insbesondere Richtkoppler.

Es sei erwähnt, dass obwohl die Erfindung anhand einer PLL bzw. Phasenregelschleife erläutert worden ist, sie jedoch auch auf Frequenzregelschleifen angewandt werden kann. Das bedeutet dann, unter einem oben erwähnten PFD soll hier ein Bauelement verstanden werden, das in Frequenzregelschleifen die Frequenzen zweier Signale vergleicht.

In PLLs werden üblicherweise Einrichtungen zur Erzeugung einer Schwingung mit steuerbarer Frequenz eingesetzt. Wie oben erwähnt, ist ein Beispiel für eine solche Einrichtung ein spannungsgesteuerter Oszillator bzw. VCO. Es ist denkbar, auch eine andere, gleichwertige Einrichtung bzw. ähnlich wirkende Mittel hierfür zu verwenden, wie beispielsweise einen NCO (Numerically Controlled Oscillator = numerisch gesteuerter Oszillator).

In den oben in den Figuren 3 bis 6 dargestellten Schaltungen haben nur der Fractional-N-Frequenzteiler VFD und ein DAC digitale Eingangssignale, und ihnen vorgelagerte Schaltungsteile arbeiten mit digitalen Signalen. Eine die Lehre der Erfindung nutzende Vorrichtung, insbesondere Sendevorrichtung, ließe sich aber auch weit gehend digital realisieren. So könnten beispielsweise die Frequenzumsetzung (vgl. Mischer MI), die Frequenzteilung (VFD), der Phasen- und/oder Frequenzvergleich (PFD), die Filterungen und die Schwingungserzeugung mit gesteuerter Frequenz auch mit digitalen Signalen erfolgen. Dabei können zusätzlicheanalog/digital- und/oder digital/analog-Umsetzungen erforderlich werden.

Wie aus den oben in den Figuren 3 bis 6 dargestellten Schaltungen zu erkennen ist, soll unter einem variablen Frequenzteiler eine Einrichtung verstanden werden, die einen ersten Eingang aufweist, an dem eine Schwingung mit einer Bezugsfrequenz anliegt, beispielsweise in Form eines zurückgeführten Signals eines VCO oder eines separaten Taktsignals, und einen zweiten Eingang aufweist, an dem ein Steuersignal anliegt, beispielsweise ein Teilungsfaktor, und einen Ausgang aufweist, an dem ein Signal mit kleinerer Frequenz als die Bezugsfrequenz ausgegeben wird, wobei das Verhältnis zwischen ausgegebener und Bezugsfrequenz durch das Steuersignal gegeben ist. Zum Beispiel können auch eine DDS (Direct Digital Synthesis: Vorrichtung zur digitalen Frequenzsynthese), die eine kontinuierliche Schwingung ausgibt, eine Pulse-Output-DDS, die im Gegensatz zur gewöhnlichen DDS Impulse anstelle kontinuierlicher Schwingungen ausgibt, und ein Zähler, der im Takt der Bezugsfrequenz zählt, der bei Erreichen des Endwerts einen Impuls ausgibt und bei dem Start- und/oder Endwert einstellbar sind, für einen solchen variablen Frequenzteiler in einer erfindungsgemäßen Vorrichtung bzw. Schaltung verwendet werden.

Der Begriff "zu erzeugende Schwingung" meint die Schwingung mit veränderlicher Frequenz. Der Begriff "erzeugte Schwingung" wird im Zusammenhang mit unterschiedlichen Schwingungen gebraucht, u.a. auch im Sinne der zu erzeugenden Schwingung.

Der Begriff "Signal" soll im weitesten Sinne verstanden werden, also nicht das Tragen von Information voraussetzen.

Schließlich soll nun noch beispielhaft eine mögliche Berechnung einer Abfolge von Teilungsfaktoren gemäß GSM erläutert werden.

In der folgenden Darstellung wird davon ausgegangen, dass ein variabler Frequenzteiler, wie der variable Frequenzteiler VFD in den Figuren 3 bis 6, mit einem Zähler realisiert ist. Der Zähler hat einen ersten Eingang, an dem ein Takt als Bezugsfrequenz anliegt. Ferner hat er einen zweiten Eingang, über den ein Steuersignal dem Zähler signalisiert, bis wieviel er zählen soll. Wenn der Zähler bis zu der durch das Steuersignal vorgegebenen Zahl gezählt hat, gibt er an seinem Ausgang einen Impuls für den Phasen-/Frequenzvergleicher (vgl. PFD in den Figuren 3 bis 6) aus, liest das aktuelle Steuersignal und zählt erneut in dem über den ersten Eingang vorgegebenen Takt bis zum Erreichen der vorgegebenen Zahl.

1. Signaldarstellung für die Phase

Zuerst wird das GSM-Signal in Inphasekomponente I und Quadraturkomponente Q mit einer hohen Überabtastung berechnet, beispielsweise mit 72 Abtastwerten pro Symbol (Abtastfrequenz $1/T_s = f_s = 19{,}5$ MHz). Daraus wird die Phase für den Phasenmodulationsanteil bestimmt. Die Phase des Signals auf der Zwischenfrequenz lautet als Funktion der Zeit:

$$\varphi_{IF}(t) \ = \ \omega_{IF}t \ + \ \arg(I(t)+jQ(t)) \ + \ 2\pi m$$

mit m ganzzahlig

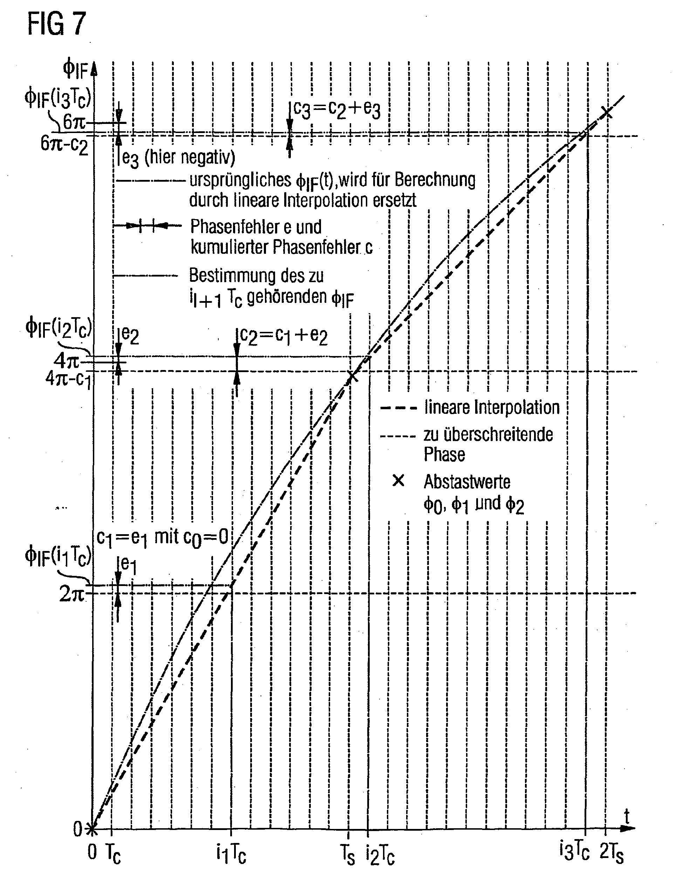

In Figur 7 ist die Phase $\varphi_{IF}$ des Signals auf der Zwischenfrequenz als Funktion der Zeit t als gepunktete Kurve dargestellt.

Da I und Q abgetastet sind, wird auch $\varphi_{IF}(t)$ nun zunächst nur für die Abtastzeitpunkte $t = kT_s$ berechnet:

$$\varphi_k \ := \ \varphi_{IF}(kT_s) \ = \ \omega_{IF}kT_s \ + \ \arg(I(kT_s)+jQ(kT_s)) \ + \ 2\pi m_k$$

mit $m_k$ ganzzahlig

In Figur 7 sind $\varphi_0$ für t=0, $\varphi_1$ für t=$T_s$ und $\varphi_2$ für t=2$T_s$ jeweils als Kreuz dargestellt.

Bei Verwendung der Funktion "Argument" (Imaginärteil des natürlichen Logarithmus) kommt es zu unerwünschten Phasensprüngen von $2\pi$, wenn der Zeiger vom zweiten in den dritten Quadranten wandert und umgekehrt. Wegen der hohen Überabtastung (und weil bei den Modulationsarten von GSM keine Nulldurchgänge auftreten) sind bei dem von der Modulation bestimmten Phasenanteil $\arg(I(kT_s)+jQ(kT_s))$ nur kleine Änderungen zwischen aufeinanderfolgenden Abtastwerten zu erwarten. Daraus kann folgender rekursiver Algorithmus zur fortlaufenden Bestimmung der $m_k$ entwickelt werden:

1. $m_0 = 0$
2. Wähle $m_{k+1} \in \{m_k\text{-}1, m_k, m_k\text{+}1\}$ so, dass

$$-\pi \ < \ \arg(I((k+1)T_s)+jQ((k+1)T_s)) \ - \ \arg(I(kT_s)+jQ(kT_s)) \ +$$
$$2\pi(m_{k+1}-m_k) \ < \ \pi$$

(Bei einer Schaltung, bei der wie in Figur 3 der Zähler mit der vom VCO erzeugten Frequenz $f_{RF}$ als Bezugsfrequenz getaktet wird, wird in den obigen Gleichungen $\arg(I+jQ)$ durch $f_{LO}/f_{RF}\cdot\arg(I+jQ)$ ersetzt, wobei $f_{LO}$ die Frequenz ist, mit der $f_{RF}$ von der Offset-PLL auf die Zwischenfrequenz umgesetzt wird.)

Zwischen den Abtastwerten $\varphi_k$ wird die zeitkontinuierliche Funktion der Phase auf der Zwischenfrequenz linear interpoliert:

$$\varphi_{IF}(t) \approx \varphi_k + (\varphi_{k+1}-\varphi_k)(t- kT_s)/T_s$$

für $kT_s \leq t < (k+1)\,T_s$

In Figur 7 ist die lineare Interpolation zwischen $\varphi_0$ bei t=0 und $\varphi_1$ bei $t=T_s$ sowie zwischen $\varphi_1$ bei $t=T_s$ und $\varphi_2$ bei $t=2T_s$ jeweils durch eine gestrichelte Linie eingezeichnet.

Der Zähler gibt Impulse ab, welche für den Beginn einer neuen Zwischenfrequenz-Periode stehen, das heißt, bei jedem Impuls des Zählers sollte die Phase des Zwischenfrequenzsignals um weitere $2\pi$ angewachsen sein. Zu bestimmen sind die Zeitpunkte, zu denen die Impulse ausgegeben werden sollen. Diese Zeitpunkte sind zeitdiskret und durch den Takt des Zählers vorgegeben. Ohne Beschränkung der Allgemeinheit wird angenommen, die Taktfrequenz des Zählers $f_c = 1/T_c$ sei ein ganzzahliges Vielfaches der Abtastfrequenz:

$$f_c = nf_s \quad \Leftrightarrow \quad T_s = nT_c$$

In der Praxis könnte n beispielsweise den Wert n = 64 annehmen. Dann ergäbe sich eine Taktfrequenz von $f_c$ = 64·$f_s$ = 1248 MHz für den Zähler.

In Figur 7 ist n = 13, das heißt $T_s = 13T_c$. Die dünnen vertikalen Linien bei Vielfachen von $T_c$ markieren die Zeitpunkte, zu denen der Zähler einen Impuls ausgeben kann.

Die Zwischenfrequenz ist durch die Rechengeschwindigkeit der Berechnungseinrichtung und durch den Ziehbereich der Offset-PLL begrenzt. Im Folgenden wird $f_{IF} > f_s$ angenommen, beispielsweise $f_{IF}$ = 50 MHz. Daraus folgt, dass zwischen einem auszugebenden Impuls und dem nächsten das gültige Interpolationsintervall k gleich bleibt oder sich um ein Intervall verschiebt. (Für $f_s/2 < f_{IF} < f_s$ würde sich das gültige Interpolationsintervall k von einem auszugebenden Impuls zum nächsten um ein oder zwei Intervalle verschieben. Der Einfluss der Modulation auf die Zwischenfrequenz wird hier vernachlässigt.) Bei $f_{IF}$ = 50 MHz und $f_c$ = 1248 MHz muss wegen $f_c/f_{IF}$ = 24,96 der Zähler im Mittel bis etwa 25 zählen.

Im Folgenden wird ein Algorithmus zur Suche entwickelt, bis wieviel der Zähler zählen muss, damit die Impulsausgabe (Phaseninkrement um $2\pi$) zum bestmöglichen Zeitpunkt kommt. Wenn wir davon ausgehen, dass die Momentanfrequenz nicht über 52 MHz steigt ($f_c$/52 MHz = 24) und wir für Quantisierung und Noise-Shaping erster Ordnung noch 2 abziehen, können wir annehmen, dass der Zähler mindestens bis 22 zählen muss. Bei der Suche brauchen wir in diesem Beispiel erst bei 22 zu beginnen.

Nehmen wir einmal an, dass wir den $\ell$-ten Impuls zum Zeitpunkt $t = i_\ell T_c$ ausgegeben haben und dabei die Phase des Zwischenfrequenzsignals auf $2\pi\ell$ erhöht haben. Dieser Zeitpunkt habe im k-ten Abtastintervall gelegen, d.h. $kT_s \leq i_\ell t_c < (k+1)T_s$. Nun bestimmen wir den Wert $i_{\ell+1}$, bei dem der folgende Impuls auszugeben ist. (Der Zähler muss dann bis $i_{\ell+1}-i_\ell$ zählen.)

Der ideale Zeitpunkt wäre durch die Gleichung $\varphi_{IF}(i_{\ell+1}T_c) = 2\pi(\ell+1)$ gegeben, wenn i eine reelle Zahl wäre. Da i eine natürliche Zahl ist, entsteht ein zeitlicher Quantisierungsfehler.

2. Phase ohne Noise-Shaping

Mögliche Berechnungsvorschrift: Wähle $i_{\ell+1}$ derart, dass $i_{\ell+1}$ der kleinste Wert ist, für den

$$\varphi_{IF}(i_{\ell+1}T_c) \geq 2\pi(\ell+1)$$

gilt. Für $i_{\ell+1}$ werden die in Frage kommenden Werte in aufsteigender Reihenfolge (beispielsweise $i_\ell+22$; $i_\ell+23$; $i_\ell+24$;...) eingesetzt, bis die Ungleichung erstmals erfüllt ist. Dabei wird je nach gültigem Abtastintervall die Interpolation

$$\varphi_{IF}(i_{\ell+1}T_c) \approx \varphi_k + (\varphi_{k+1}-\varphi_k)(i_{\ell+1}T_c - kT_s)/T_s$$

für $kT_s \le i_{\ell+1}T_c < (k+1) T_s$
oder

$$\varphi_{IF}(i_{\ell+1}T_c) \approx \varphi_{k+1} + (\varphi_{k+2}-\varphi_{k+1})(i_{\ell+1}T_c - (k+1)T_s)/T_s$$

für $(k+1) T_s \le i_{\ell+1}T_c < (k+2)T_s$
verwendet. Zur Unterscheidung, welche Interpolation zutrifft, muss die Bedingung $i_{\ell+1}T_c < (k+1)T_s$ ausgewertet werden. Mit $T_s = nT_c$ kann diese Ungleichung in $i_{\ell+1} < n(k+1)$ umgeschrieben werden. Dabei braucht die rechte Seite dieser Ungleichung pro Schritt nur einmal berechnet zu werden.

Mit $T_s = nT_c$ werden die Interpolationsgleichungen zu

$$\varphi_{IF}(i_{\ell+1}T_c) \approx \varphi_k + (\varphi_{k+1}-\varphi_k)(i_{\ell+1}/n - k)$$

für $i_{\ell+1} < n(k+1)$
oder

$$\varphi_{IF}(i_{\ell+1}T_c) \approx \varphi_{k+1} + (\varphi_{k+2}-\varphi_{k+1})(i_{\ell+1}/n - k - 1)$$

sonst.

Dabei ist eine Division durch n erforderlich. Mit $n = 64 = 2^6$ entspricht diese Division einer Rechtsverschiebung um 6 Binärstellen.

Bei diesem Vorgehen entsteht (abgesehen von dem Fehler durch die lineare Interpolation und Rundungsfehlern) ein Phasenfehler

$$e_{\ell+1} = \varphi_{IF}(i_{\ell+1}T_c) - 2\pi(\ell+1) ,$$

der sich aus der Phasendifferenz zwischen der eigentlich gewünschten Phase zum Zeitpunkt der Impulsausgabe $\varphi_{IF}(i_{\ell+1}Tc)$ und der durch die Impulsausgabe erreichten Phase $2\pi(\ell+1)$ ergibt. Der zugrunde liegende Zeitfehler liegt gleichverteilt im halboffenen Intervall $[0; T_c)$. Falls die Momentanfrequenz $f_{IF}$ ist, ist $e \in [0; 2\pi f_{IF} T_c)$. Für unser Beispiel mit $f_c/f_{IF} \approx 25$ liegt der Phasenfehler etwa zwischen 0° und 14°. Der Phasenfehler setzt sich aus einem unschädlichen Mittelwert und einem weiteren Anteil zusammen, der im Idealfall ein spektral weißes Quantisierungsgeräusch wäre, das durch die zeitliche Quantisierung des Arguments von $\varphi_{IF}$ bedingt ist. Da aber aufeinanderfolgende Quantisierungsfehler wegen der niedrigen Anzahl praktisch relevanter Quantisierungsstufen auch nach Abzug des mittleren Fehlers nicht orthogonal zueinander, sondern korreliert sind, ergeben sich ungünstigere spektrale Eigenschaften, z.B. unerwünschte Nebenlinien im Spektrum, sogenannte "Spurious". Die Modulation und ein Noise-Shaping können den Nebenlinien entgegen wirken.

3. Phase mit Noise-Shaping erster Ordnung

Der kumulierte Phasenfehler wird c genannt und rekursiv berechnet:

$$c_{\ell+1} = \sum_{p=0}^{\ell+1} e_p = c_\ell + e_{\ell+1}$$

Damit $c_{\ell+1}$ null wird, muss $e_{\ell+1} = -C_\ell$ gelten. Daraus folgt

$$\varphi_{IF}(i_{\ell+1}T_c) - 2\pi(\ell+1) = -c_\ell .$$

Deshalb wird die Berechnungsvorschrift umformuliert in "Wähle $i_{\ell+1}$ derart, dass $i_{\ell+1}$ der kleinste Wert ist, für den

$$\varphi_{IF}(i_{\ell+1}T_c) \geq 2\pi(\ell+1) - c_\ell$$

gilt." Nun wird der Fehler aufsummiert und gegengekoppelt.

Figur 7 zeigt die Bestimmung der $i_\ell$ mit Noise-Shaping erster Ordnung. Für den kumulierten Phasenfehler c wird der Startwert $c_0=0$ angenommen. Damit lautet für $\ell=0$ die obige Berechnungsvorschrift: "Wähle $i_1$ derart, dass $i_1$ der kleinste Wert ist, für den $\varphi_{IF}(i_1T_c) \geq 2\pi$ gilt." Eine horizontale, kurz gestrichelte Linie zeigt die zu überschreitende Phase. Dabei wird die gestrichelte Interpolation zugrunde gelegt. Ab $t=7T_c$, d.h. $i_1=7$, ist diese Ungleichung erfüllt.

$$\varphi_{IF}(i_1T_c) = \varphi_{IF}(7T_c)$$

ist etwas größer als $2\pi$, und die Differenz

$$\varphi_{IF}(i_1T_c) - 2\pi \text{ ist } e_1.$$

Zur Bestimmung von $\varphi_{IF}(i_1T_c)$ wird gemäß

$$\varphi_{IF}(i_{\ell+1}T_c) \approx \varphi_k + (\varphi_{k+1}-\varphi_k)(i_{\ell+1}/n - k)$$

für $i_{\ell+1} < n(k+1)$
mit $\ell=0$, $k=0$, $\varphi_0=0$, $i_1=7$ und $n=13$ interpoliert:

$$\varphi_{IF}(7T_c) \approx 7\varphi_1/13$$

Für den kumulierten Phasenfehler c gilt: $c_1 = c_0 + e_1 = e_1$. Für die nächste Zwischenfrequenz-Periode ($\ell=1$) lautet die Berechnungsvorschrift: "Wähle $i_2$ derart, dass $i_2$ der kleinste Wert ist, für den $\varphi_{IF}(i_2T_c) \geq 4\pi-c_1$ gilt." Wieder zeigt eine horizontale, kurz gestrichelte Linie die zu überschreitende Phase. Diese Ungleichung ist erst im folgenden Interpolationsintervall ($T_s \leq i_2T_c < 2T_s$, d.h. $13 \leq i_2 < 26$) erfüllt, und zwar für $i_2=14$. Zur Bestimmung von $\varphi_{IF}(i_2T_c)$ wird gemäß $\varphi_{IF}(i_{\ell+1}T_c) \approx \varphi_{k+1} + (\varphi_{k+2}-\varphi_{k+1})(i_{\ell+1}/n - k - 1)$ für $i_{\ell+1} \geq n(k+1)$ interpoliert: $\varphi_{IF}(14T_c) \approx \varphi_1+(\varphi_2-\varphi_1)(14/13-1) = (12\varphi_1+\varphi_2)/13$. Der Index k der Abtastwerte von $\varphi$ wird um 1 auf $k=1$ erhöht, um die Basis für die im folgenden Schritt zu berechnende Interpolation auf das Intervall zu legen, in dem der zuletzt gefundene Wert $i_{\ell+1}$ liegt. Bei diesem Schritt kommt der Fehler $e_2 = \varphi_{IF}(i_2T_c)-4\pi$ hinzu. Der kumulierte Phasenfehler ist $c_2 = c_1+e_2 = \varphi_{IF}(i_2T_c) - (4\pi-c_1)$.

Für die darauf folgende Zwischenfrequenz-Periode $\ell=2$ lautet die Berechnungsvorschrift: "Wähle $i_3$ derart, dass $i_3$ der kleinste Wert ist, für den $\varphi_{IF}(i_3T_c) \geq 6\pi-c_2$ gilt." Auch hier zeigt eine horizontale, kurz gestrichelte Linie die zu überschreitende Phase. Diese Ungleichung ist im gleichen Interpolationsintervall wie bei $\ell=1$ erfüllt, und zwar für $i_2=25$. Zur Bestimmung von $\varphi_{IF}(i_3T_c)$ wird gemäß $\varphi_{IF}(i_{\ell+1}T_c) \approx \varphi_k + (\varphi_{k+1}-\varphi_k)(i_{\ell+1}/n - k)$ für $i_{\ell+1} < n(k+1)$ interpoliert: $\varphi_{IF}(25T_c) \approx \varphi_1+(\varphi_2-\varphi_1)(25/13-1) = (\varphi_1+12\varphi_2)/13$. Bei diesem Schritt kommt der Fehler $e_3 = \varphi_{IF}(i_3T_c)-6\pi$ hinzu. Der kumulierte Phasenfehler ist $c_3 = c_2+e_3 = \varphi_{IF}(i_3T_c)-(6\pi-c_2)$.

Die Werte N, die das Steuersignal für den Zähler ergeben, lauten gemäß dieser Rechnung (unter der Annahme $i_0=0$):

$i_1 - i_0 = 7 - 0 = 7$
$i_2 - i_1 = 14 - 7 = 7$
$i_3 - i_2 = 25 - 14 = 11$

4. Phase mit Noise-Shaping zweiter Ordnung

Ein Noise-Shaping höherer Ordnung ließe sich durch andere Definitionen und Berechnungsvorschriften erreichen, für zweite Ordnung beispielsweise durch:

$$x_{\ell+1} := 2\pi(\ell+1) - 2e_\ell + e_{\ell-1}$$

mit

$$e_{\ell+1} := \varphi_{IF}(i_{\ell+1}T_c) - x_{\ell+1}$$

und

"Wähle $i_{\ell+1}$ derart, dass $i_{\ell+1}$ der kleinste Wert ist, für den $\varphi IF(i_{\ell+1}T_c) \geq x_{\ell+1}$ gilt."

**Patentansprüche**

1. Vorrichtung zum Erzeugen einer Schwingung mit veränderlicher Frequenz, mit folgenden Merkmalen:

einem variablen Frequenzteiler (VFD) mit:

einem ersten Eingang zum Eingeben einer Bezugsfrequenz ($f_{RF}$; $F_{VCO}$) ;
einem zweiten Eingang zum Eingeben eines Steuersignals (N) zum Festlegen des Teilungsverhältnisses von der Bezugsfrequenz zu einer Ausgangsfrequenz;
einem Ausgang zum Ausgeben der Ausgangsfrequenz ($f_{IF'}$);

einer Regelschleife mit:

einem Vorwärtszweig umfassend eine Einrichtung (VCO) zum Erzeugen einer Schwingung mit einer ersten Frequenz ($f_{RF}$, $f_{VCO}$) und mit Mitteln, um aus der Schwingung mit erster Frequenz die Schwingung mit veränderlicher Frequenz ($f_{RF}$) abzuleiten;
einem Rückführungszweig umfassend eine Einrichtung (MI) zur Frequenzumsetzung und einen Lokaloszillator (LO), um unter Verwendung der Referenzfrequenz ($f_{LO}$) des Lokaloszillators (LO) die Schwingung mit veränderlicher Frequenz ($f_{RF}$) auf eine Schwingung mit zweiter Frequenz ($f_{IF}$) umzusetzen;
einer Einrichtung (PFD) zum Phasen- und/oder Frequenzvergleich umfassend einen ersten Eingang zum Eingeben der Schwingung mit zweiter Frequenz ($f_{IF}$), einen zweiten Eingang zum Eingeben der Ausgangsfrequenz ($f_{IF'}$), und einen Ausgang, welche Einrichtung (PFD) den Anfang des Vorwärtszweigs bildet und dafür ausgelegt ist, ein Regelsignal (SR) für die Einrichtung zum Erzeugen der Schwingung mit erster Frequenz auszugeben,

**dadurch gekennzeichnet, dass**
der erste Eingang des variablen Frequenzteilers (VFD) mit dem Vorwärtszweig hinter der Einrichtung zur Erzeugung der Schwingung mit erster Frequenz gekoppelt ist, so dass die Bezugsfrequenz ($f_{RF}$;$f_{VCO}$) von der zu erzeugenden Schwingung mit veränderlicher Frequenz ($f_{RF}$) abhängt.

2. Vorrichtung nach Anspruch 1, bei der der variable Frequenzteiler (VFD) derart mit der Einrichtung (VCO) zum Erzeugen einer Schwingung mit erster Frequenz verbunden ist, dass die erzeugte Schwingung mit erster Frequenz oder ein von dieser abgeleitetes Signal als Bezugsfrequenz in den ersten Eingang des variablen Frequenzteilers eingeht.

3. Vorrichtung nach einem der Ansprüche 1 bis 2, wobei die Einrichtung (MI) zur Frequenzumsetzung einen Frequenzmischer aufweist mit:

einem ersten Eingang zum Eingeben der Schwingung mit erster Frequenz oder einem von dieser abgeleiteten Signal;
einem zweiten Eingang zum Eingeben der Schwingung mit der Referenzfrequenz oder einem von dieser abgeleiteten Signal;
einem Ausgang zum Ausgeben der Schwingung mit zweiter Frequenz.

4. Vorrichtung nach einem der Ansprüche 1 bis 3, die ferner eine Einrichtung (CALC) zum Erzeugen einer Abfolge von Teilungsfaktoren (N) aufweist, welche als das Steuersignal (N) in den zweiten Eingang des variablen Frequenzteilers (VFD) eingeht, um in diesem ein gewünschtes Teilungsverhältnis festzulegen.

**5.** Vorrichtung nach einem der Ansprüche 1 bis 4, bei der die Regelschleife ferner eine Einrichtung (LF) zur Bandbegrenzung der Bandbreite der Regelschleife, insbesondere in Form eines Schleifenfilters (LF) zwischen der Einrichtung (PFD) zum Phasen- und/oder Frequenzvergleich und der Einrichtung (VCO) zum Erzeugen einer Schwingung mit einer ersten Frequenz, aufweist.

**6.** Vorrichtung nach einem der Ansprüche 1 bis 5, bei der die Regelschleife ferner einen zweiten Frequenzteiler (FFD1) aufweist, der der Einrichtung (VCO) zum Erzeugen einer Schwingung mit erster Frequenz ($f_{VCO}$) nachgeschaltet ist und dafür ausgelegt ist, ein von der Schwingung mit erster Frequenz ($f_{VCO}$) abgeleitetes Signal mit einem bestimmten Teilungsverhältnis zu dieser zu bilden.

**7.** Vorrichtung nach einem der Ansprüche 1 bis 6, bei der der Vorwärtszweig einen Leistungsverstärker (PA) zum Erzeugen eines Sendesignals auf der Basis der Schwingung mit erster Frequenz ($f_{RF},f_{VCO}$) oder eines von dieser abgeleiteten Signals aufweist, der der Einrichtung (VCO) zum Erzeugen einer Schwingung mit erster Frequenz ($f_{RF}$, $f_{VCO}$) nachgeschaltet ist.

**8.** Vorrichtung nach Anspruch 7, die ferner eine Einrichtung (PSD) zur Darstellung und/oder Zerlegung einer Modulationsinformation für das Sendesignal nach Amplitude und Winkel aufweist.

**9.** Vorrichtung nach Anspruch 7 oder 8, die ferner eine Einrichtung (CTRL) zur Amplitudenmodulation des Sendesignals aufweist, welche mit dem Leistungsverstärker (PA) verbunden ist.

**10.** Sendevorrichtung mit einer Vorrichtung zum Erzeugen einer Schwingung mit veränderlicher Frequenz gemäß einem der Ansprüche 1 bis 9.

**11.** Kommunikationsgerät mit einer Vorrichtung nach einem der Ansprüche 1 bis 9.

**12.** Kommunikationsgerät nach Anspruch 11, das als ein Mobilfunkgerät oder Mobiltelefon ausgebildet ist.

**13.** Kommunikationsgerät nach einem der Ansprüche 11 oder 12, das nach dem GSM-Standard arbeitet.

**Claims**

**1.** Device for generating an oscillation having a variable frequency, with the following features:

a variable frequency divider (VFD) comprising:

a first input for inputting a reference frequency ($f_{RF}$; $f_{VCO}$) ;
a second input for inputting a control signal (N) for establishing the dividing ratio of the reference frequency to an output frequency;
an output for outputting the output frequency ($f_{IF'}$);

a control loop comprising:

a forward path comprising a device (VCO) for generating an oscillation having a first frequency ($f_{RF}$, $f_{VCO}$) and comprising means for deriving from the oscillation having a first frequency the oscillation having a variable frequency ($f_{RF}$);
a feedback path comprising a device (MI) for frequency conversion and a local oscillator (LO) for converting the oscillation having a variable frequency ($f_{RF}$) to an oscillation having a second frequency ($f_{IF}$) by using the reference frequency ($f_{LO}$) of the local oscillator (LO);
a device (PFD) for phase and/or frequency comparison comprising a first input for inputting the oscillation having the second frequency ($f_{IF}$), a second input for inputting the output frequency ($f_{IF'}$), and an output, which device (PFD) forms the start of the forward path and is designed for outputting a control signal (SR) for the device for generating the oscillation having the first frequency,

**characterized in that**
the first input of the variable frequency divider (VFD) is coupled to the forward path behind the device for generating the oscillation having the first frequency, so that the reference frequency ($f_{RF}$; $f_{VCO}$) depends on the oscillation having the variable frequency ($f_{RF}$) to be generated.

2. Device according to Claim 1, in which the variable frequency divider (VFD) is connected to the device (VCO) for generating an oscillation having the first frequency in such a manner that the generated oscillation having the first frequency or a signal derived from it enters the first input of the variable frequency divider as reference frequency.

3. Device according to one of Claims 1 to 2, wherein the device (MI) for frequency conversion has a frequency mixer, comprising:

   a first input for inputting the oscillation having the first frequency or a signal derived from it;
   a second input for inputting the oscillation having the reference frequency or a signal derived from it;
   an output for outputting the oscillation having the second frequency.

4. Device according to one of Claims 1 to 3, which also has a device (CALC) for generating a sequence of dividing factors (N) which enters the second input of the variable frequency divider (VFD) as the control signal (N) in order to establish in it a desired dividing ratio.

5. Device according to one of Claims 1 to 4, in which the control loop also has a device (LF) for limiting the bandwidth of the control loop, particularly in the form of a loop filter (LF) between the device (PFD) for phase and/or frequency comparison and the device (VCO) for generating an oscillation having a first frequency.

6. Device according to one of Claims 1 to 5, in which the control loop also has a second frequency divider (FFD1) which follows the device (VCO) for generating an oscillation having the first frequency ($f_{VCO}$) and is designed for forming a signal derived from the oscillation having the first frequency ($f_{VCO}$) with a particular dividing ratio to this frequency.

7. Device according to one of Claims 1 to 6, in which the forward path has a power amplifier (PA) for generating a transmitting signal on the basis of the oscillation having the first frequency ($f_{RF}$, $f_{VCO}$) or a signal derived from it, which is followed by the device (VCO) for generating an oscillation having the first frequency ($f_{RF}$, $f_{VCO}$).

8. Device according to Claim 7 which also has a device (PSD) for representing and/or splitting modulation information for the transmitting signal in accordance with amplitude and angle.

9. Device according to Claim 7 or 8 which also has a device (CTRL) for the amplitude modulation of the transmitting signal, which is connected to the power amplifier (PA).

10. Transmitting device with a device for generating an oscillation having a variable frequency according to one of Claims 1 to 9.

11. Communication device with a device according to one of Claims 1 to 9.

12. Communication device according to Claim 11 which is constructed as a mobile radio device or mobile telephone.

13. Communication device according to one of Claims 11 or 12, which operates in accordance with the GSM standard.

**Revendications**

1. Dispositif pour générer une oscillation à fréquence variable, possédant les caractéristiques suivantes :

   un diviseur de fréquence variable (VFD) pourvu :

   d'une première entrée pour entrer une fréquence de référence ($f_{RF}$; $f_{VCO}$) ;
   d'une seconde entrée pour entrer un signal de commande (N) pour fixer le rapport de division de la fréquence de référence par rapport à une fréquence de sortie ;
   d'une sortie pour délivrer la fréquence de sortie ($f_{IF'}$) ;

   une boucle de régulation comprenant :

un chemin vers l'avant comprenant un dispositif (VCO) pour générer une oscillation ayant une première fréquence ($f_{RF}$, $f_{VCO}$) et des moyens pour dériver l'oscillation à fréquence variable ($f_{RF}$) à partir de l'oscillation de première fréquence ;

un chemin de rétroaction comprenant un dispositif (MI) de conversion de fréquence et un oscillateur local (LO) pour convertir l'oscillation à fréquence variable ($f_{RF}$) en une oscillation de seconde fréquence ($f_{IF}$) en utilisant la fréquence de référence ($f_{LO}$) de l'oscillateur local (LO) ;

un dispositif (PFD) de comparaison de phase et/ou de fréquence comprenant une première entrée pour entrer l'oscillation de seconde fréquence ($f_{IF}$), une seconde entrée pour entrer la fréquence de sortie ($f_{IF'}$) et une sortie, lequel dispositif (PFD) forme le début du chemin vers l'avant et est étudié pour délivrer en sortie un signal de régulation (SR) pour le dispositif

de génération de l'oscillation de première fréquence,

**caractérisé en ce que**

la première entrée du diviseur de fréquence variable (VFD) est couplée au chemin vers l'avant derrière le dispositif de génération de l'oscillation de première fréquence, de manière à ce que la fréquence de référence ($f_{RF}$; $F_{VCO}$) dépend de l'oscillation à fréquence variable ($f_{RF}$) devant être générée.

2. Dispositif selon la revendication 1, dans lequel le diviseur de fréquence variable (VFD) est relié au dispositif (VCO) de génération d'une oscillation de première fréquence de manière à ce que l'oscillation de première fréquence générée ou un signal dérivé de celle-ci entre dans la première entrée du diviseur de fréquence variable en tant que fréquence de référence.

3. Dispositif selon l'une des revendications 1 à 2, le dispositif (MI) de conversion de fréquence comprenant un mélangeur de fréquence pourvu :

d'une première entrée pour entrer l'oscillation de première fréquence ou un signal dérivé de celle-ci ;
d'une seconde entrée pour entrer l'oscillation à fréquence de référence ou un signal dérivé de celle-ci ;
d'une sortie pour délivrer en sortie l'oscillation de seconde fréquence.

4. Dispositif selon l'une des revendications 1 à 3, comprenant, en outre, un dispositif (CALC) pour générer une suite de facteurs de division (N) qui entre dans la seconde entrée du diviseur de fréquence variable (VFD) en tant que signal de commande (N) pour fixer un rapport de division souhaité dans le diviseur.

5. Dispositif selon l'une des revendications 1 à 4, dans lequel la boucle de régulation comprend, en outre, un dispositif (LF) de limitation de la bande passante de la boucle de régulation, sous forme notamment d'un filtre de boucle (LF) entre le dispositif (PFD) de comparaison de phase et/ou de fréquence et le dispositif (VCO) de génération d'une oscillation de première fréquence.

6. Dispositif selon l'une des revendications 1 à 5, dans lequel la boucle de régulation comprend, en outre, un second diviseur de fréquence (FFD1) branché derrière le dispositif (VCO) de génération d'une oscillation de première fréquence ($f_{VCO}$) et étudié pour former un signal dérivé de l'oscillation de première fréquence ($f_{VCO}$) avec un rapport de division déterminé par rapport à celle-ci.

7. Dispositif selon l'une des revendications 1 à 6, dans lequel le chemin vers l'avant comprend un amplificateur de puissance (PA) pour générer un signal d'émission sur la base de l'oscillation de première fréquence ($f_{RF}$, $f_{VCO}$) ou un signal dérivé de celle-ci, qui est branché derrière le dispositif (VCO) de génération d'une oscillation de première fréquence ($f_{RF}$, $f_{VCO}$).

8. Dispositif selon la revendication 7, comprenant, en outre, un dispositif (PSD) de représentation et/ou décomposition d'une information de modulation pour le signal d'émission en fonction de l'amplitude et de l'angle.

9. Dispositif selon la revendication 7 ou 8, comprenant, en outre, un dispositif (CTRL) de modulation en amplitude du signal d'émission qui est relié à l'amplificateur de puissance (PA).

10. Émetteur comprenant un dispositif pour générer une oscillation à fréquence variable selon l'une des revendications 1 à 9.

11. Appareil de communication comprenant un dispositif selon l'une des revendications 1 à 9.

**12.** Appareil de communication selon la revendication 11, exécuté en tant qu'appareil de radiotéléphonie mobile ou téléphone mobile.

**13.** Appareil de communication selon l'une des revendications 11 ou 12, fonctionnant selon la norme GSM.

# FIG 1

# FIG 2

# FIG 3

# FIG 4

# FIG 5

# FIG 6

PSD ─── Polare Signaldarstellung

CALC ◄──── Phase

N ↓

VFD

$f_{IF'}$ ↓

PFD ── SR → LF → VCO → FFD1 →

LIM ◄──── $f_{IF}$ ──── LPF ◄── MI ◄── 

ED

CTRL

Amplitude

PA

$f_{RF}$

FFD2

$f_{LO}$

LO

## FIG 7

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

*   US 5847615 A

**In der Beschreibung aufgeführte Nicht-Patentliteratur**

*   **PETROVIC, V. ; GOSLING, W.** Polarloop transmitter. *Electronic letters,* 1979, vol. 15 (10), 286-288